# EUROPÄISCHE PATENTSCHRIFT

(11) **EP 4 706 353 B1**
(45) Veröffentlichungstag und Bekanntmachung des Hinweises auf die Patenterteilung: **14.10.2026**
(21) Anmeldenummer: 25709993.7
(22) Anmeldetag: 28.02.2025
(51) Int. Cl.: H10N 60/01

(54) **SUBELEMENT FÜR EINEN HALBZEUGDRAHT ZUR HERSTELLUNG EINES NB3SN-SUPRALEITERDRAHTS**
SUB-ELEMENT FOR A SEMI-FINISHED WIRE FOR PRODUCING AN NB3SN SUPERCONDUCTOR WIRE
ÉLÉMENT PARTIEL D'UN FIL DEMI-FINI DESTINÉ À LA FABRICATION D'UN FIL SUPRACONDUCTEUR NB3SN

(30) Priorität: 09.04.2024 DE 102024109846
(43) Veröffentlichungstag der Anmeldung: 11.03.2026
(73) Patentinhaber: Bruker EAS GmbH, 63450 Hanau (DE)
(72) Erfinder: WANIOR, Matheus, 63571 Gelnhausen (DE); BÜHLER, Carl, 63505 Langenselbold (DE); SAILER, Bernd, 63755 Alzenau (DE); ABÄCHERLI, Vital, 63526 Erlensee (DE); AUBELE, André, 63512 Hainburg (DE)
(74) Vertreter: Kohler Schmid Möbus Patentanwälte
(86) Internationale Anmeldenummer: PCT/EP2025/055526
(87) Internationale Veröffentlichungsnummer: WO 2025/214655

(56) Entgegenhaltungen:
- EP-A1- 2 099 080
- EP-A1- 3 961 658
- EP-A2- 0 169 078
- DE-A1- 102019 204 926
- JP-B2- 3 948 291
- RU-C1- 2 770 617
- US-A1- 2013 053 250
- US-A1- 2014 287 929

## Beschreibung

Die Erfindung betrifft ein Subelement für einen Halbzeugdraht zur Herstellung eines Nb₃Sn-Supraleiterdrahts,
wobei das Subelement umfasst
- einen Sn-haltigen Kernbereich,
- einen Cu-haltigen, inneren Matrixbereich, der den Sn-haltigen Kernbereich umgibt,
- einen Bündelbereich, umfassend eine Vielzahl von aneinander anliegenden Nb-haltigen Stabelementen, wobei der Bündelbereich den inneren Matrixbereich umgibt,
- einen Zwischenbereich, der den Bündelbereich umgibt,
- eine umlaufende Diffusionsbarriere, die den Zwischenbereich umgibt, und
- einen Cu-haltigen Hüllbereich, der die Diffusionsbarriere umgibt.

Ein solches Subelement ist aus der EP 1 719 190 B1 bekannt geworden.

Supraleitende Materialien können elektrischen Strom ohne nennenswerte ohmsche Verluste transportieren. Aus supraleitenden Drähten werden beispielsweise Magnetspulen gewickelt, die sehr hohe Magnetfeldstärken erzeugen können, wie sie beispielsweise in der NMR-Spektroskopie gewünscht werden.

Trotz großer Fortschritte bei Hochtemperatursupraleiter-Materialien sind in der praktischen Anwendung nach wie vor Tieftemperatursupraleiter-Materialien (mit einer Sprungtemperatur von 40 K oder weniger) weiter von großer Bedeutung. Insbesondere werden in der Herstellung von Magnetspulen für hohe Magnetfeldstärken Nb₃Sn-haltige Supraleiterdrähte eingesetzt. Die Supraleiterdrähte sollen zum einen eine hohe Stromtragfähigkeit aufweisen, und zum anderen sollen die Supraleiterdrähte mechanisch robust sein, um den Belastungen bei der Anwendung standzuhalten.

Die Herstellung von Nb₃Sn-Supraleiterdrähten umfasst die Herstellung eines unreagierten Halbzeugdrahtes, der Nb und Sn enthält. Der Halbzeugdraht wird in eine gewünschte Form gebracht, beispielsweise zu einer Spule gewickelt, und einer Reaktionswärmebehandlung unterzogen. Dabei reagiert im Halbzeugdraht enthaltenes Nb mit im Halbzeugdraht enthaltenem Sn zur supraleitenden Nb₃Sn-Phase, wodurch der Halbzeugdraht in einen Supraleiterdraht transformiert wird.

Für die Herstellung eines Nb₃Sn-Supraleiterdrahtes bzw. des zugehörigen Halbzeugdrahts sind verschiedene Routen bekannt geworden, die sich teilweise erheblich unterscheiden. Bei der Bronze-Route ist das benötigte Sn in einer Bronze-Legierung im Halbzeugdraht enthalten. In der Internen-Zinn-Methode (internal tin) liegt im Allgemeinen bis zur Wärmebehandlung das Sn getrennt neben dem Cu im Halbzeugdraht vor.

Aus der eingangs genannten EP 1 719 190 B1 ist ein Verfahren bekannt geworden, dass auf einer Internen-Zinn-Methode basiert. Dabei werden zunächst Subelemente gefertigt, wobei jedes Subelement einen Sn-haltigen Kern (Kernbereich) aufweist, der von einem inneren Teil einer Cu-haltigen Matrix (innerer Matrixbereich) umgeben ist. Darum herum sind eine Vielzahl von Nb-haltigen Filamenten (Nb-haltigen Stabelementen) aneinander liegend angeordnet, die jeweils einen Nb-haltigen Kern und eine Cu-Umhüllung aufweisen. Der Bereich (Bündelbereich) der Nb-haltigen Filamente ist wiederum von einem äußeren Teil der Cu-haltigen Matrix umgeben. Um den äußeren Teil der Cu-haltigen Matrix ist eine umlaufende Diffusionsbarriere aus Nb angeordnet. Diese wird von einem Mantel (Hüllbereich) aus Cu umgeben. Mehrere dieser Subelemente werden in einer Cu-Matrix gebündelt und einer Querschnittsverjüngung unterzogen, wodurch ein Halbzeugdraht erhalten wird. Dieses Verfahren ist auch unter der Bezeichnung "Restack Rod Process" (RRP^{®}) bekannt geworden.

Ein ähnliches Vorgehen wird auch in der DE 10 2019 204 926 beschrieben.

Das RRP^{®}-Verfahren wird zudem auch ausführlich diskutiert in C. Sanabrina, "A new understanding of the heat treatment of Nb-Sn superconducting wires", PhD Thesis, Florida State University, Tallahassee, US, 2017.

Bei der Reaktionswärmebehandlung eines solchen Halbzeugdrahtes können nach den Erkenntnissen der Erfinder in dem Bereich des äußeren Teils der Cu-haltigen Matrix der Subelemente, also in dem Zwischenbereich zwischen dem Bündelbereich und der Diffusionsbarriere, durch Diffusionsvorgänge merkliche Leerräume entstehen. Diese Leerräume tragen zum einen nicht zur supraleitenden Stromtragfähigkeit des Supraleiterdrahts bei. Zum anderen stellen die Leerräume mechanische Schwachstellen dar, von denen Risse ausgehen können, insbesondere wenn der fertige Supraleiterdraht in der Anwendung merklichen Kräften, beispielsweise Lorentz-Kräften in einem Magneten, ausgesetzt ist. Solche Risse können die supraleitende Stromtragfähigkeit verringern. Zusätzlich kommt es im Bereich der Porosität zu lokalen Spannungserhöhungen, die sich negativ auf die supraleitenden Eigenschaften des betroffenen Nb₃Sn auswirken.

Aus I. Pong et al., Supercond. Sci. Technol. 26 (2013) 105002, ist es bekannt geworden, dass bei der Reaktionswärmebehandlung um die Nb-haltigen Filamente (Nb-haltigen Stabelemente) herum Porosität entstehen kann. Große Kirkendall-Poren wurden typischerweise in Richtung auf die Diffusionsbarriere zu beobachtet.

W. L. Neijmeijer, in "Microstructural and kinetic studies of the manufacturing of superconducting Nb3Sn", Dissertation, Universiteit Twente, Enschede, NL, 1988, beschreibt, dass Poren und Spalten Stresszentren bilden, die Risse in der spröden Nb₃Sn-Phase auslösen können.

T. Bagni et al., Supercond. Sci. Technol. 35 (2022), 104003, beschreibt die Entstehung und Ausbreitung von Rissen in RRP^{®} Nb₃Sn-Drähten. In Magnetanwendungen können insbesondere periodische Lorentz-Kräfte zu Spannungen führen. Bei Spannungen über 150 MPa wurden Risse im gebildeten Nb₃Sn beobachtet.

C. Senatore et al., Supercond. Sci. Technol. 36 (2023), 075001, beschreiben die Degradierung des kritischen Stroms in Nb₃Sn-Drähten aufgrund von Eigenspannungen.

In der EP 2 717 340 A2 wird vorgeschlagen, die Cu-haltigen Hüllen der Nb-haltigen Elemente (Nb-haltigen Stabelemente) mit Sn anzureichern.

In der EP 3 420 565 B1 wird vorgeschlagen, die Cu-haltige Matrix, in der die kupferkaschierten Nb-Stäbe (Nb-haltigen Stabelemente) angeordnet sind, als eine Bronze mit niedrigem Sn-Gehalt auszubilden.

Weiteres gehen aus US 2013/053250 A1, EP 3 961 658 A1, EP 2 099 080 A1 und RU 2 770 617 C1 Halbzeuge der eingangs beschriebenen Art hervor.

Die US 2014/287929 A1 beschreibt zudem ein Monofilament und ein Verfahren zur Herstellung eines Precursors mit diesem Monofilament im Rahmen eines PIT-Verfahrens.

### Aufgabe der Erfindung

Es ist Aufgabe der Erfindung, die supraleitende Stromtragfähigkeit und die mechanische Robustheit eines Nb₃Sn-Supraleiterdrahts zu verbessern.

### Beschreibung der Erfindung

Diese Aufgabe wird erfindungsgemäß gelöst durch ein Subelement der eingangs genannten Art, das dadurch gekennzeichnet ist,
dass im Zwischenbereich Nb-haltige Füllelemente angeordnet sind, welche jeweils eine Geometrie haben, die sich von der Geometrie der Nb-haltigen Stabelemente unterscheidet.

Die Erfindung schlägt vor, in den Subelementen für den Halbzeugdraht jeweils in dem Zwischenbereich zwischen dem Bündelbereich der aneinander anliegenden, meist hexagonalen, Nb-haltigen Stabelemente und der typischerweise kreisringförmigen Diffusionsbarriere Nb-haltige Füllelemente anzuordnen.

Diese Nb-haltigen Füllelemente haben eine andere Geometrie als die (in der Regel einheitliche) Geometrie der Nb-haltigen Stabelemente des Bündelbereichs. Dadurch können die Nb-haltigen Füllelemente an den verfügbaren Raum im Zwischenbereich angepasst werden. Insbesondere können in dem Zwischenbereich noch Nb-haltige Füllelemente angeordnet werden, wo eine Anordnung von weiteren Nb-haltigen Stabelementen (mit der im Bündelbereich verwendeten Geometrie) nicht mehr möglich wäre.

Bei der Reaktionswärmebehandlung eines aus den Subelementen gefertigten Halbzeugdrahts kann in dem Zwischenbereich der Subelemente aus den Nb-haltigen Füllelementen weiteres Nb₃Sn gebildet werden. Das zusätzlich gebildete Nb₃Sn trägt zur supraleitenden Stromtragfähigkeit bei, und die Bildung von Leerräumen im Querschnitt des fertigen Nb₃Sn-Supraleiterdrahts wird vermieden. Je nach Reaktionsführung und dem Anteil an im Subelementquerschnitt zur Verfügung stehendem Sn kann gegebenenfalls auch etwas unreagiertes Nb im vormaligen Zwischenbereich verbleiben; in diesem Fall wird zumindest die Bildung von Leerräumen vermindert. Durch die Minimierung von Leerräumen im Querschnitt des fertigen Nb₃Sn-Supraleiterdrahts wird der Supraleiterdraht mechanisch robuster, und die Entstehung und Ausbreitung von Rissen wird vermindert, insbesondere auch unter der Einwirkung von äußeren Kräften, beispielweise Lorentz-Kräften. Dadurch wird auch die Degradierung der supraleitenden Stromtragfähigkeit (bzw. des kritischen Stroms) bei der Anwendung minimiert.

Die Erfindung unterscheidet sich somit vom üblichen Stand der Technik, bei dem Folgendermaßen vorgegangen wird: Im Stand der Technik wird in dem Zwischenraum (Zwischenbereich) zwischen dem Bündelbereich der Nb-haltigen Stabelemente und der Diffusionsbarriere eine Kupfermatrix angeordnet. Somit kann während der Reaktionswärmebehandlung das Kupfer wegdiffundieren, insbesondere nach radial innen in Richtung Kernbereich. Die zuvor vom Kupfer eingenommenen Räume werden dann zu Leerräumen, die die mechanische Stabilität des fertigen Nb₃Sn-Supraleiterdrahts beeinträchtigen, und auch nicht zur supraleitenden Stromtragfähigkeit beitragen.

Die Erfinder haben festgestellt, dass beim erfindungsgemäßen Design trotz der vergleichsweisen großen Entfernung der Nb-haltigen Füllelemente im Zwischenbereich zum Sn-haltigen Kernbereich bei einer herkömmlichen Reaktionswärmebehandlung das Niob in den Nb-haltigen Füllelementen dennoch zu einem großen Teil zu Nb₃Sn umgesetzt werden kann. Eine Anordnung von zusätzlichen Sn-Quellen im Bündelbereich oder Zwischenbereich ist im Allgemeinen nicht notwendig, kann aber im Rahmen der Erfindung erfolgen, falls gewünscht. Gegenüber einem herkömmlichen Subelementdesign kann, falls nötig, der Sn-Anteil im Subelementquerschnitt, insbesondere durch einen vergrößerten Sn-haltigen Kernbereich, im Rahmen der Erfindung etwas erhöht werden, um das zusätzlich zur Verfügung stehenden Nb in den Nb-haltigen Füllelementen zu Nb₃Sn umsetzen zu können.

Da Cu die Bildung von Nb₃Sn katalysiert und zudem die Diffusion von Sn in Cu im Vergleich zur Nb₃Sn-Bildung schnell ist, kann im Rahmen der Erfindung auch im Zwischenbereich ein Teil des Subelementquerschnitts von Cu oder einer Cu-haltigen Phase eingenommen werden und/oder ein gewisser Anteil Cu in den im Zwischenbereich verbauten Elementen/Strukturen vorhanden sein. Jedoch sollte im Zwischenbereich der Teil des Subelementquerschnitts, der von Cu oder Cu-haltigen Phasen eingenommen wird, gering sein (typischerweise 40% oder weniger, bevorzugt 20%, besonders bevorzugt 10% oder weniger, bezogen auf den Gesamtquerschnitt der im Zwischenbereich verbauten Elemente/Strukturen), und/oder der Anteil von Cu in den im Zwischenbereich verbauten Elementen/Strukturen sollte gering sein (typischerweise im Mittel über alle Elemente/Strukturen im Zwischenbereich 40 Gew% oder weniger, bevorzugt 20 Gew% oder weniger, besonders bevorzugt 10 Gew% oder weniger). Durch einen geringen Gehalt an Cu im Zwischenbereich wird der Bildung von Leerräumen wirksam vorgebeugt. Typischerweise beträgt der Anteil an Nb im Zwischenbereich (im Mittel über alle Elemente/Strukturen, die im Zwischenbereich angeordnet sind) typischerweise 50 Gew% oder mehr, bevorzugt 60 Gew% oder mehr, besonders bevorzugt 80 Gew% oder mehr. Weiterhin wird der Zwischenbereich im Querschnitt, bezogen auf die Fläche, typischerweise zu wenigstens 50%, bevorzugt zu wenigstens 60%, besonders bevorzugt zu wenigstens 70%, von Elementen/Strukturen (das sind Nb-haltige Füllelemente und ggf. Zusatzelemente/Zusatzstrukturen) eingenommen.

Durch den vergleichsweise hohen Füllgrad und insbesondere die Homogenisierung der mechanischen Eigenschaften bei der Verwendung von Nb-haltigen Füllelementen im Zwischenbereich stellt sich zudem ein gutes Umformverhalten bei querschnittsverringernden Umformungen des Subelements (einzeln oder in einem Halbzeugdraht) ein. Insbesondere wird bei diesen Umformungen die Diffusionsbarriere nicht beschädigt, und schützt den umgebenden Cu-haltigen Hüllbereich des Subelements (und noch weiter außen liegende Strukturen) vor einer Kontamination mit Zinn während der Wärmebehandlung. Ein gutes Umformverhalten kann auch dann erhalten werden, wenn kein Cu im Zwischenbereich verbaut ist; gleichwohl können im Rahmen der Erfindung auch Cu oder Cu-haltige Phasen im Zwischenbereich verbaut werden, bevorzugt aber nur in geringem Umfang (siehe oben).

Die unterschiedliche Geometrie der Nb-haltigen Füllelemente im Zwischenbereich einerseits und der Nb-haltigen Stabelemente im Bündel-Bereich andererseits kann im Querschnitt eine unterschiedliche äußere Form und/oder eine unterschiedliche Größe beinhalten. Die Nb-haltigen Füllelemente enthalten zumindest eine Phase, die Nb enthält, typischerweise wobei diese Phase fest ausgebildet ist; alternativ kann auch diese Phase pulvrig sein. Die Nb-haltigen Stabelemente sind typischerweise mit einem Nb-Kern (Nb-Stab) und einer diesen umgebenden Cu-Hülle (Cu-Hüllrohr) gefertigt. Typischerweise haben alle Nb-haltigen Stabelemente im Bündelbereich eine einheitliche identische Geometrie (im Querschnitt gleiche Form, typischerweise hexagonal, und gleiche Größe); falls im Bündelbereich weitere Stabelemente angeordnet sein sollten, haben diese typischerweise dieselbe Geometrie. In vielen Anwendungsfällen ist der Zwischenbereich so schmal, dass keine Nb-haltigen Stabelemente aus dem Bündelbereich dort mehr platziert werden können. Er kann jedoch z. B. durch kleinere Nb-haltige Füllelemente ausgefüllt werden.

### Bevorzugte Ausführungsformen der Erfindung

Bei einer bevorzugten Ausführungsform des erfindungsgemäßen Subelements weisen die Nb-haltigen Stabelemente einen hexagonalen Querschnitt auf. Dadurch lassen sich die Nb-haltigen Stabelemente (und ggf. weitere Stabelemente derselben Geometrie) besonders einfach und dicht bündeln, typischerweise ohne Lücken.

Besonders bevorzugt ist eine Ausführungsform, die vorsieht, dass die Nb-haltigen Stabelemente jeweils eine Querschnittsfläche ASE aufweisen, und dass zumindest ein Teil der Nb-haltigen Füllelemente jeweils eine Querschnittsfläche AFE aufweist, mit AFE<ASE. Die Nb-haltigen Füllelemente mit (im Vergleich zu den Nb-haltigen Stabelementen) kleiner Querschnittsfläche können sehr gut Räume im Zwischenbereich ausfüllen, in die keine Nb-haltigen Stabelemente mehr passen. Dadurch kann die erreichbare supraleitende Stromtragfähigkeit im fertigen Supraleiterdraht und die mechanische Belastbarkeit gesteigert werden.

Ebenso besonders bevorzugt ist eine Ausführungsform, die vorsieht,
dass die Nb-haltigen Stabelemente im Querschnitt jeweils eine größte Länge LSE aufweisen, und zumindest ein Teil der Nb-haltigen Füllelemente im Querschnitt jeweils eine größte Länge LFE aufweist, mit LFE<LSE,
   und/oder
dass die Nb-haltigen Stabelemente im Querschnitt jeweils eine größte Breite BSE senkrecht zur Richtung ihrer größten Länge LSE aufweisen, und zumindest ein Teil der Nb-haltigen Füllelemente im Querschnitt jeweils eine größte Breite BFE senkrecht zur Richtung ihrer größten Länge LFE aufweist, mit BFE<BSE.

Die Nb-haltigen Füllelemente mit geringerer Länge LFE und/oder geringerer Breite BFE (im Vergleich zu den Nb-haltigen Stabelementen mit LSE und BSE) können ebenfalls sehr gut Räume im Zwischenbereich ausfüllen, in denen keine Nb-haltigen Stabelemente mehr passen, oder allgemein kleine verbleibende Räume und Spalten um Zwischenbereich. Dadurch kann ebenfalls die erreichbare supraleitende Stromtragfähigkeit im fertigen Supraleiterdraht gesteigert werden. Bevorzugt gilt zumindest für einen Teil der Nb-haltigen Füllelemente LFE≤0,75*LSE, bevorzugt LFE≤0,50*LSE, und/oder BFE≤0,75*BSE, bevorzugt BFE≤0,50*BSE.

Vorteilhaft ist auch eine Ausführungsform, bei der vorgesehen ist, dass die Nb-haltigen Stabelemente im Querschnitt jeweils eine Aspektverhältnis AVSE aufweisen, und dass zumindest ein Teil der Nb-haltigen Füllelemente im Querschnitt jeweils eine Aspektverhältnis AVFE aufweisen, mit AVFE>AVSE. Nb-haltige Füllelemente mit hohem Aspektverhältnis sind besonders gut geeignet, um die abschnittsweise näherungsweise sichelförmigen Räume im Zwischenbereich aufzufüllen, oder auch kleine Spalten im Zwischenbereich. Man beachte, dass Nb-haltige Füllelemente gemäß dieser Ausführungsform sowohl größer als auch kleiner sein können als die Nb-haltigen Stabelemente des Bündelbereichs.

Bei einer vorteilhaften Ausführungsform sind im Zwischenbereich Nb-haltige Füllelemente von wenigstens zwei verschiedenen Typen angeordnet sind, wobei sich die verschiedenen Typen der Nb-haltigen Füllelemente zumindest in ihrer Geometrie unterscheiden. Die unterschiedliche Geometrie der verschiedenen Typen der Nb-haltigen Füllelemente im Zwischenbereich kann eine unterschiedliche äußere Form und/oder eine unterschiedliche Größe beinhalten. Mit mehreren Typen von Nb-haltigen Füllelementen kann ein besonders hoher Füllgrad im Zwischenbereich des Subelements erreicht werden.

Vorteilhaft ist eine Ausführungsform, bei der zumindest ein Teil der Nb-haltigen Füllelemente im Querschnitt außen kreisrund ausgebildet ist. Runde Nb-haltige Füllelemente sind einfach herzustellen und können im Zwischenbereich von Subelementen universell eingesetzt werden. Eine besondere Anpassung des Querschnitts der Nb-haltigen Füllelemente an den konkreten Subelementtypus (beispielsweise an die Anzahl, Größe und Anordnung der verbauten Nb-haltigen Stabelemente der den Innendurchmesser der Diffusionsbarriere) ist nicht nötig.

Besonders bevorzugt ist eine Ausführungsform, bei der zumindest ein Teil der Nb-haltigen Füllelemente im Querschnitt außen polygonal, insbesondere hexagonal, ausgebildet ist. Mit polygonalen Nb-haltigen Füllelemente können besonders große Füllgrade im Zwischenbereich und/oder große geschlossene befüllte Flächen im Zwischenbereich erreicht werden. Beispielsweise können hexagonale und rautenförmige Nb-haltige Füllelemente sehr gut kombiniert werden, so dass nur noch minimale Freiräume nach Zusammensetzung des Subelements im Zwischenbereich verbleiben; die Geometrie von drei Ecken der zugehörigen Raute entspricht bevorzugt der Geometrie von drei zusammenhängenden Ecken des zugehörigen Hexagons.

Vorteilhaft ist eine Ausführungsform, bei der zumindest bei einem Teil der Nb-haltigen Füllelemente ein jeweiliges Füllelement im Querschnitt
- an einer radial innen liegenden Seite eine Profilierung entsprechend einem Teilstück eines äußeren Randes des Bündelbereichs aufweist, und
- an einer radial äußeren Seite eine runde Profilierung entsprechend einem Teilstück der Innenseite der Diffusionsbarriere aufweist.

Mit entsprechenden Füllelementen kann der Zwischenbereich praktisch vollständig aufgefüllt werden. Damit werden besonders hohe supraleitende Stromtragfähigkeiten im fertigen Supraleiterdraht erreichbar. Im Falle von hexagonalen Nb-haltigen Stabelementen hat die radial innen liegende Seite eine abschnittweise gerade verlaufende Profilierung.

Bevorzugt ist weiterhin eine Ausführungsform, bei der zumindest ein Teil der Nb-haltigen Füllelemente weiterhin Cu-haltig ist. Mit Cu kann die Bildung des Nb₃Sn katalysiert werden, und die Diffusion von Sn zum Niob wird beschleunigt. Zudem kann Cu oder eine Cu-haltige Phase das Verformungsverhalten der Nb-haltigen Füllelemente bei querschnittsverjüngenden Umformungen verbessern.

Besonders bevorzugt ist eine Ausführungsform, bei der zumindest bei einem Teil der Nb-haltigen Füllelemente ein jeweiliges Füllelement im Querschnitt
- zumindest eine Zone einer ersten, Nb-haltige Phase aufweist, und
- zumindest eine Zone einer zweiten, Cu-haltige Phase aufweist.

Mit diesem Aufbau ist es auf einfache Weise möglich, Cu in die Nb-haltigen Subelemente einzubringen, insbesondere in praktisch beliebigen Stoffmenge-Verhältnissen. Man beachte, dass in einem jeweiligen Nb-haltigen Füllelement der Gehalt an Cu typischerweise bei 40 Gew% oder weniger, bevorzugt 20 Gew% oder weniger, ganz besonders bevorzugt 10 Gew% oder weniger beträgt. Eine Cu-haltige Phase kann zudem das Ziehverhalten des Subelements verbessern.

Bei einer vorteilhaften Weiterbildung dieser Ausführungsform ist vorgesehen, dass zumindest bei einem Teil der Nb-haltigen Füllelemente ein jeweiliges Füllelement im Querschnitt
- eine Kernzone der ersten, Nb-haltigen Phase aufweist, und
- eine Kaschierzone der zweiten, Cu-haltigen Phase aufweist, welche die Kernzone vollständig umschließt.

Dieser Aufbau ist vergleichsweise einfach, und ermöglicht einen raschen Transport von Sn zum Nb in der Kernzone der Nb-haltigen Füllelemente von allen Seiten, und dadurch besonders gleichmäßig. Die Kernzone und die Kaschierzone können insbesondere konzentrisch (zu einem Zentrum des Nb-haltigen Füllelements) ausgebildet sein.

Bevorzugt ist auch eine Weiterbildung, die vorsieht, dass zumindest bei einem Teil der Nb-haltigen Füllelemente ein jeweiliges Füllelement im Querschnitt
- eine hintere Zone der ersten, Nb-haltigen Phase aufweist, welche radial außen an die Diffusionsbarriere angrenzt, und
- eine vordere Zone der zweiten, Cu-haltigen Phase aufweist, welche radial innen an den Bündelbereich angrenzt und die hintere Zone vom Bündelbereich abtrennt.

Mit diesem Aufbau kann Sn von radial innen, insbesondere vom Sn-haltigen Kernbereich des Subelements, besonders effizient in die Nb-haltige Phase transportiert werden. Insbesondere kann vorgesehen sein, dass die vordere Zone die hintere Zone U-Förmig umgreift.

Eine ebenfalls bevorzugte Weiterbildung sieht vor, dass zumindest bei einem Teil der Nb-haltigen Füllelemente ein jeweiliges Füllelement im Querschnitt
- als Schichtstruktur mit mehreren ersten Schichtzonen der ersten, Nb-haltigen Phase und mehreren zweiten Schichtzonen der zweiten, Cu-haltigen Phase ausgebildet ist,
- und erste Schichtzonen und zweite Schichtzonen alternieren.

Durch die Schichtstruktur kann der Zugang von Sn (das durch die zweiten Schichtzonen transportiert wird) zu den ersten Schichtzonen verbessert werden, und insgesamt die Bildung von Nb₃Sn im Zwischenbereich beschleunigt werden. Insbesondere kann vorgesehen sein, dass die ersten Schichtzonen und zweiten Schichtzonen in Bezug auf das Subelement im Wesentlichen radial ausgerichtet sind; dies verbessert den raschen Zugang des Sn vom Kernbereich des Subelements zum Nb in den Nb-haltigen Füllelementen noch weiter.

Bevorzugt ist eine Weiterbildung, die vorsieht, dass zumindest bei einem Teil der Nb-haltigen Füllelemente ein jeweiliges Füllelement im Querschnitt
- als aufgerollte Struktur mit einer aufgerollten Schichtzone der ersten, Nb-haltigen Phase und einer aufgerollten Schichtzone der zweiten, Cu-haltigen Phase ausgebildet ist, wobei diese aufgerollten Schichtzonen zusammen aufeinander gerollt sind, und/oder
- als Multifilament-Struktur mit einer Matrixzone der zweiten, Cu-haltigen Phase und mehreren Filamentzonen der ersten, Nb-haltigen Phase, die in der Matrixzone verteilt angeordnet sind, ausgebildet ist.

Auf diese Weise ist es möglich, in den Nb-haltigen Füllelementen den maximalen Abstand zwischen Cu und Nb im Querschnitt des Subelements gering zu halten, wodurch die Bildung von Nb₃Sn beschleunigt werden kann.

Bei einer vorteilhaften Weiterbildung sind zumindest bei einem Teil der Nb-haltigen Füllelemente eine oder mehrere Zonen der ersten, Nb-haltigen Phase und ein oder mehrere Zonen der zweiten, Cu-haltigen Phase konzentrisch im Nb-haltigen Füllelement angeordnet. Die Zonen der ersten Phase und der zweiten Phase sind also um ein gemeinsames Zentrum des jeweiligen Nb-haltigen Füllelements angeordnet. Auf diese Weise ist es ebenfalls möglich, in den Nb-haltigen Füllelementen den maximalen Abstand zwischen Cu und Nb im Querschnitt des Subelements gering zu halten, wodurch die Bildung von Nb₃Sn beschleunigt werden kann.

Bei einer vorteilhaften Ausführungsform ist vorgesehen,
dass zumindest ein Teil der Nb-haltigen Füllelemente als Dotier-Füllelemente ausgebildet ist, wobei die Dotier-Füllelemente in zumindest einer enthaltenen Phase wenigstens ein Element der vierten Nebengruppe des Periodensystems enthalten,
   und/oder
dass im Zwischen-Bereich auch Dotier-Zusatzelemente angeordnet sind, wobei die Dotier-Zusatzelemente in zumindest einer enthaltenen Phase wenigstens ein Element der vierten Nebengruppe des Periodensystems enthalten,
insbesondere wobei das wenigstens eine Element der vierten Nebengruppe des Periodensystems Titan umfasst.

Mit einem Zusatz von chemischen Elementen der vierten Nebengruppe, insbesondere Ti, kann im Nb₃Sn-Supraleiterdraht das Gefüge verfeinert werden, und es können höhere supraleitende Stromtragfähigkeiten erreicht werden. Titan kann beispielsweise in Dotier-Füllelementen mit einem Kern aus einer Nb-Ti-Legierung zugesetzt werden. Im Falle von Dotier-Zusatzelementen können beispielsweise diese aus Titan bestehen oder einen Kern aus Titan enthalten, der mit einer Cu-Kaschierung versehen ist.

Vorteilhaft ist auch eine Ausführungsform, die vorsieht,
dass zumindest ein Teil der Nb-haltigen Füllelemente als Verstärkungs-Füllelemente ausgebildet ist, wobei die Verstärkungs-Füllelemente in zumindest einer enthaltenen Phase wenigstens ein Element der fünften Nebengruppe des Periodensystems enthalten,
   und/oder
dass im Zwischen-Bereich auch Verstärkungs-Zusatzelemente angeordnet sind, wobei die Verstärkungs-Zusatzelemente in zumindest einer enthaltenen Phase wenigstens ein Element der fünften Nebengruppe des Periodensystems enthalten,
insbesondere wobei das wenigstens eine Element der fünften Nebengruppe des Periodensystems Tantal umfasst. Mit einem Zusatz von chemischen Elementen der fünften Nebengruppe, insbesondere Ta, kann eine mechanische Verstärkung erreicht werden.

Eine bevorzugte Ausführungsform sieht vor, dass zumindest bei einem Teil der Nb-haltigen Füllelemente das jeweilige Füllelement
- weiterhin auch Sn enthält,
- bevorzugt wobei das jeweilige Füllelement im Querschnitt zumindest eine Zone einer ersten, Nb-haltigen Phase und zumindest eine Zone einer zweiten, Cu-haltigen Phase aufweist, und das Sn in der Cu-haltigen Phase enthalten ist,
- besonders bevorzugt wobei eine Kernzone der ersten, Nb-haltigen Phase von einer Kaschierzone der zweiten, Cu-haltigen Phase, in der auch das Sn enthalten ist, vollständig umschlossen ist.

Das zusätzliche Zinn in den Nb-haltigen Füllelementen kann unmittelbar als Quelle zur Bildung von Nb₃Sn beitragen, zusätzlich zum Sn-haltigen Kernbereich des Subelements. Zudem können Cu-haltige Phasen im Bereich der Nb-haltigen Füllelemente durch von Anfang an enthaltenes Sn oder auch schnell aus der nahen Umgebung eindiffundierendes Sn den Transport von Sn aus dem Kernbereich zum Nb in den Nb-haltigen Füllelementen beschleunigen.

Ebenfalls in den Rahmen der vorliegenden Erfindung fällt ein Verfahren zur Herstellung eines Nb₃Sn-Supraleiterdrahts, umfassend zumindest folgende Schritte:
Schritt 1) Fertigung mehrerer Subelemente gemäß einem der vorhergehenden Ansprüche;
Schritt 2) Bündelung mehrerer gefertigter Subelemente zu einem Halbzeugdraht;
Schritt 3) Reaktionswärmebehandlung des Halbzeugdrahts, wobei Sn und Nb aus dem Halbzeugdraht zu Nb₃Sn reagieren.

Mit dem erfindungsgemäßen Verfahren wird ein Nb₃Sn-Supraleiterdraht erhalten, der eine besonders hohe Stromtragfähigkeit und hohe mechanische Robustheit erreichen kann. Man beachte, dass Schritt 1) typischerweise auch eine querschnittsreduzierende Umformung der Subelemente umfasst. Man beachte, dass Schritt 2) typischerweise auch eine querschnittsreduzierende Umformung des Halbzeugdrahtes umfasst. Zudem kann die Bündelung der Subelemente einstufig oder mehrstufig erfolgen. Man beachte, dass die Reaktionswärmebehandlung in Schritt 3) mit dem Halbzeugdraht in einer gewünschten Form erfolgt (zB aufgewickelt zu einer Spule), und insofern typischerweise auch eine vorausgehende Formgebung umfasst. Die Reaktionswärmebehandlung sieht typischerweise mehrere Wärmebehandlungsstufen (Temperaturplateaus, bei denen eine konstante Temperatur für einige Zeit, meist einige Stunden, gehalten wird) vor. Beispielsweise kann ein erstes Temperaturplateau bei 200-220°C liegen, ein zweites Temperaturplateau bei 350-400°C liegen, und ein drittes Temperaturplateau bei 600-750°C liegen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1a: zeigt im schematischen Querschnitt eine Ausführungsform eines erfindungsgemäßen Subelements, mit Nb-haltigen Füllelementen in zwei Typen, die fein verteiltes Nb enthalten;
- Fig. 1b: zeigt schematisch eines der Nb-haltigen Füllelemente sowie ein Nb-haltiges Stabelement aus Fig. 1a, im maßstabsgetreuen Vergleich;
- Fig. 2: zeigt im schematischen Querschnitt eine weitere Ausführungsform eines erfindungsgemäßen Subelements, mit Nb-haltigen Füllelementen, die fein verteiltes Nb enthalten, und Verstärkungs-Zusatzelementen;
- Fig. 3a: zeigt im schematischen Querschnitt eine weitere Ausführungsform eines erfindungsgemäßen Subelements, mit Nb-haltigen Füllelementen mit einer in Umfangsrichtung ausgerichteten Schichtstruktur;
- Fig. 3b: zeigt schematisch einen vergrößerten Ausschnitt aus Fig. 3a;
- Fig. 4a: zeigt im schematischen Querschnitt eine weitere Ausführungsform eines erfindungsgemäßen Subelements, mit Nb-haltigen Füllelementen mit einer radial ausgerichteten Schichtstruktur;
- Fig. 4b: zeigt schematisch einen vergrößerten Ausschnitt aus Fig. 4a;
- Fig. 5a: zeigt im schematischen Querschnitt eine weitere Ausführungsform eines erfindungsgemäßen Subelements, mit verschieden großen, kreisrunden Nb-haltigen Füllelementen;
- Fig. 5b: zeigt schematisch einen vergrößerten Ausschnitt aus Fig. 5a;
- Fig. 5c: zeigt schematisch die unterschiedlichen Nb-haltigen Füllelemente sowie eines der Nb-haltigen Stabelemente aus Fig. 5a, im maßstabsgetreuen Vergleich;
- Fig. 6: zeigt im schematischen Querschnitt eine weitere Ausführungsform eines erfindungsgemäßen Subelements, mit verschieden großen, kreisrunden Nb-haltigen Füllelementen sowie Dotier-Zusatzelementen;
- Fig. 7: zeigt im schematischen Querschnitt verschiedene Typen von Nb-haltigen Füllelementen jeweils mit wenigstens einer Zone einer ersten, Nb-haltigen Phase und wenigstens einer Zone einer zweiten, Cu-haltigen Phase;
- Fig. 8: zeigt im schematischen Querschnitt eine weitere Ausführungsform eines erfindungsgemäßen Subelements, mit zwei Typen von Nb-haltigen Füllelementen, wobei in einem Typ mehrere Filamentzonen einer ersten, Nb-haltigen Phase vorhanden ist;
- Fig. 9a: zeigt im schematischen Querschnitt eine weitere Ausführungsform eines erfindungsgemäßen Subelements, mit zwei Typen von Nb-haltigen Füllelementen, wobei ein Typ hexagonal und ein Typ rautenförmig ausgebildet ist;
- Fig. 9b: zeigt schematisch einen vergrößerten Ausschnitt aus Fig. 9a;
- Fig. 10a: zeigt im schematischen Querschnitt eine weitere Ausführungsform eines erfindungsgemäßen Subelements, mit zwei Typen von Nb-haltigen Füllelementen, die jeweils eine hintere Zone einer ersten, Nb-haltigen Phase und eine vordere Zone einer zweiten, Cu-haltigen Phase aufweisen;
- Fig. 10b: zeigt schematisch einen vergrößerten Ausschnitt aus Fig. 10a;
- Fig. 11: zeigt schematisch den Ablauf einer beispielhaften Variante eines erfindungsgemäßen Verfahrens zur Herstellung eines Nb₃Sn-Supraleiterdrahts.

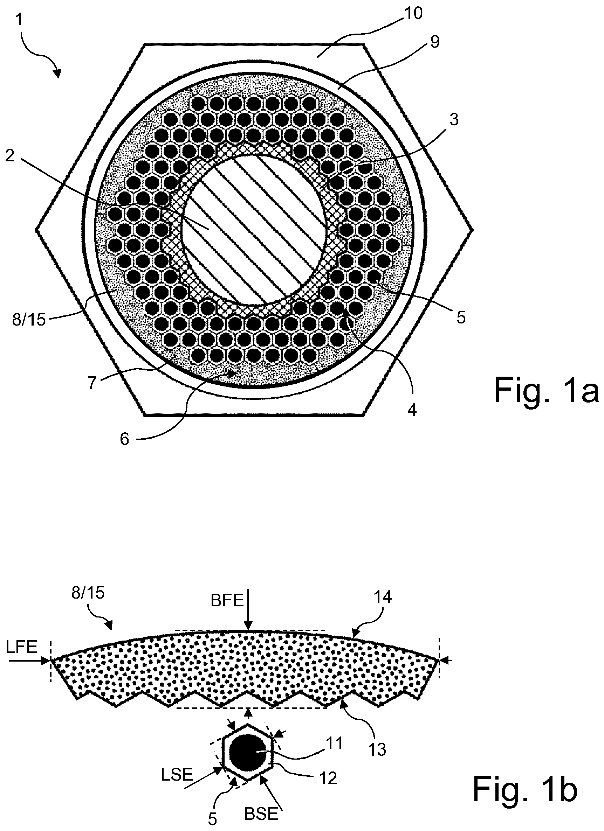

Die **Fig. 1a** zeigt in einem schematischen Querschnitt eine erste, beispielhafte Ausführungsform eines erfindungsgemäßen Subelements 1.

Das Subelement 1 umfasst einen Sn-haltigen Kernbereich 2, der hier durch einen festen Sn-Stab ausgebildet ist. Alternativ kann der Sn-haltige Kernbereich auch durch ein Pulver oder eine Pulvermischung ausgebildet sein, die Sn-Pulver und/oder Sn-haltiges Pulver enthält (nicht dargestellt). Der Sn-haltige Kernbereich 2 ist hier nach radial außen hin kreisrund ausgebildet.

Der Sn-haltige Kernbereich 2 ist von einem Cu-haltigen, inneren Matrixbereich 3 umgeben. Der Cu-haltige Matrixbereich 3 wird hier durch entsprechend geformtes, elementares Cu ausgebildet. Der Cu-haltige, innere Matrixbereich 3 ist hier nach außen hin abschnittweise gerade profiliert, entsprechend dem angrenzenden Bündelbereich 4.

Der Cu-haltige, innere Matrixbereich 3 ist umgeben vom Bündelbereich 4, der durch eine Vielzahl von aneinander anliegenden, Nb-haltigen Stabelementen 5 gebildet wird. Die Nb-haltigen Stabelemente 5 sind hier im Außenquerschnitt jeweils hexagonal ausgebildet und gleich groß.

Der Bündelbereich 4 wird umgeben von einem Zwischenbereich 6, in welchem Nb-haltige Füllelemente 7, 8 angeordnet sind. In der gezeigten Bauform sind zwei Typen von Nb-haltigen Füllelementen 7, 8 verbaut. Die Nb-haltigen Füllelemente 7 sind kleiner als die Nb-haltigen Füllelemente 8. Die Nb-haltigen Füllelemente 7, 8 sind hier nach radial innen abschnittweise gerade profiliert, entsprechend dem angrenzenden Bündelbereich 4. Nach radial außen hin sind die Nb-haltigen Füllelemente 7, 8 rund ausgebildet, entsprechend der angrenzenden Diffusionsbarriere 9.

An den Zwischenbereich 6 grenzt nach außen hin die Diffusionsbarriere 9 an, die hier radial innen und außen kreisrund ausgebildet ist. Die Diffusionsbarriere 9 ist also entsprechend einem kreiszylindrischen Rohr ausgebildet. Die Diffusionsbarriere 9 ist beispielsweise auf Nb oder V oder Ta ausgebildet.

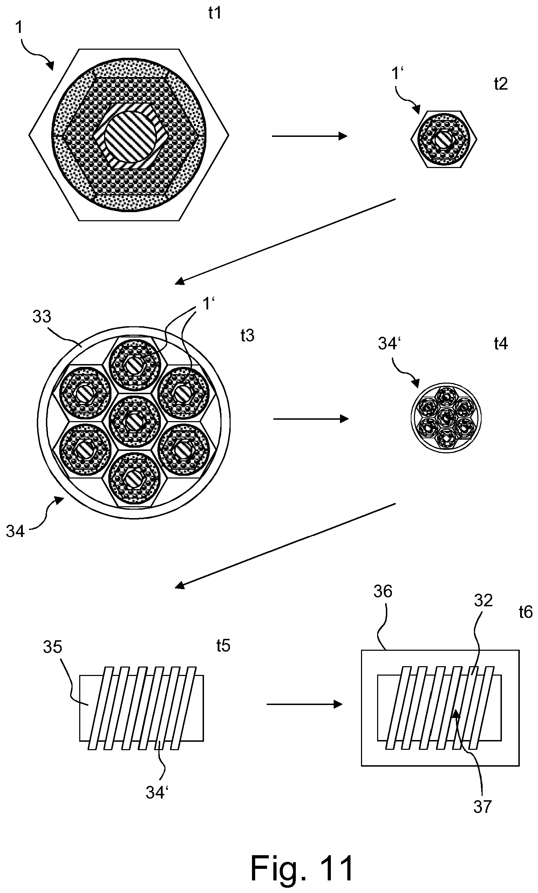

Die Diffusionsbarriere 9 verhindert während der Reaktionswärmebehandlung ein Vordringen von Sn nach radial außen in einen Cu-haltigen Hüllbereich 10, der hier aus elementarem Cu gefertigt ist. Dadurch kann der Cu-haltige Hüllbereich 10 im fertigen Supraleiterdraht eine hohe ohmsche Leitfähigkeit bewahren. Der Cu-haltige Hüllbereich 10 ist hier außen hexagonal ausgebildet, was ein späteres Bündeln zu einem Halbzeugdraht erleichtert (siehe Fig. 11 hierzu).

Die **Fig. 1b** zeigt vergrößert, aber zueinander maßstabsgetreu, ein Nb-haltiges Stabelement 5 und ein Nb-haltiges Füllelement 8 von Fig. 1a.

Das Nb-haltige Stabelement 5 weist einen hier festen Nb-Kern 11 auf, der von einer Cu-Hülle 12 umgeben ist. Der Nb-Kern 11 ist hier außen rund. Die Cu-Hülle 12 ist innen entsprechend rund, und außen hexagonal ausgebildet.

Das Nb-haltige Füllelement 8 weist auf einer Seite (im Subelement nach radial innen gerichtet) die abschnittweise gerade Profilierung 13 auf, und auf der anderen Seite (im Subelement nach radial außen gerichtet) die runde (kreisförmig gebogene) Profilierung 14 auf. Das Nb-haltige Füllelement 8 enthält hier fein und gleichmäßig verteilt Nb; im gezeigten Ausführungsbeispiel ist das Nb-haltige Füllelement 8 aus einer Legierung gefertigt, die zu 92,5 Gew% aus Nb und zu 7,5 Gew% aus Ta besteht (Nb7.5Ta). Durch den Ta-Gehalt kann das Füllelement 8 auch als Verstärkungs-Füllelement 15 dienen.

Das Nb-haltige Füllelement 8 hat eine größte Länge LFE und dazu senkrecht eine zugehörige, größte Breite BFE, und damit ein Aspektverhältnis AVFE=LFE/BFE, wobei AVFE hier ca. 4,9 beträgt.

Das Nb-haltige Stabelement 5 hat eine größte Länge LSE (zwischen gegenüberliegenden Ecken) und dazu senkrecht eine zugehörige, größte Breite BSE (zwischen gegenüberliegenden Seiten), und damit ein Aspektverhältnis AVSE=LSE/BSE, wobei AVSE hier ca. 1,2 beträgt. In der gezeigten Bauform ist somit AVFE>AVSE.

In der gezeigten Bauform, siehe Fig. 1a, wäre der Zwischenbereich 6 an einigen Stellen noch weit genug, um noch ein paar weitere Nb-haltige Stabelemente aufzunehmen. Davon wurde jedoch hier abgesehen, um am Rand des Bündelbereichs 4 vergleichsweise lange, randständige gerade Schichtabschnitte von Nb-haltigen Stabelementen 5 anzuordnen, und weiterhin die Nb-haltigen Füllelemente 7, 8 überall mit vergleichsweise großer Breite auszubilden zu können. Dies erleichtert die Fertigung.

Die nachfolgend erläuterten, weiteren Ausführungsformen von Subelementen für die Erfindung entsprechend weitgehend dem Subelement 1 von Fig. 1a, so dass nur die wesentlichen Unterschiede erläutert werden; die Unterschiede beschränken sich meist auf den Zwischenbereich und die dortigen Füllelemente.

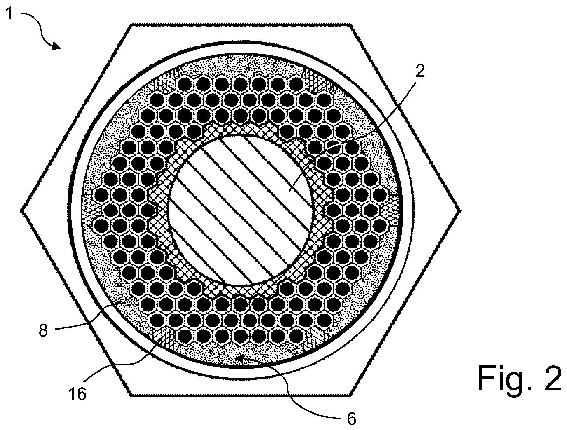

In der Ausführungsform des Subelements 1, welches in **Fig.** 2 dargestellt ist, weist im Zwischenbereich 6 hier die Nb-haltigen Füllelemente 8 auf, und weiterhin Dotier-Zusatzelemente 16. Diese enthalten in der gezeigten Bauform eine Legierung aus Cu und Ti. Während der Reaktionswärmebehandlung können das Cu und das Ti aus den Dotier-Zusatzelementen 16 die Bildung der Nb₃Sn-Phase aus dem Nb aus den Nb-haltigen Füllelementen 8 und aus dem Sn aus dem Sn-haltigen Kernbereich 2 mit hoher supraleitender Stromtragfähigkeit unterstützen.

In einer Variante der Bauform von Fig. 2 können anstelle von Dotier-Zusatzelementen 16 auch Verstärkungs-Zusatzelemente verbaut werden, die beispielsweise aus Tantal gefertigt sind oder Tantal enthalten (nicht näher dargestellt).

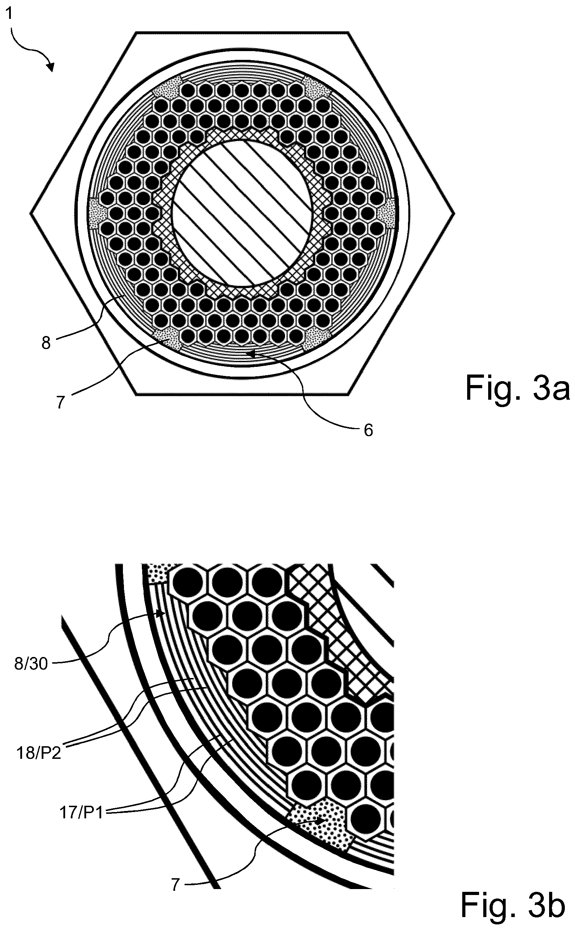

Die **Fig. 3a** in Gesamtüberblick und die **Fig. 3b** mit einem vergrößerten Ausschnitt aus Fig. 3a zeigen ein Subelement 1 in einer Ausführungsform, bei der wiederum zwei Typen von Nb-haltigen Füllelementen 7, 8 verbaut sind. Während die kleineren Nb-haltigen Füllelemente 7 hier fein verteiltes Nb enthalten, weisen die größeren Nb-haltigen Füllelemente 8 hier eine Schichtstruktur 30 auf.

Die Schichtstruktur 30 wird gebildet durch mehrere erste Schichtzonen 17 einer ersten, niobhaltigen Phase P1 (zB aus Nb7.5Ta), und mehreren zweiten Schichtzonen 18 einer zweiten, Cu-haltigen Phase P2 (zB aus Cu0.5Sn). Die ersten Schichtzonen 17 und die zweiten Schichtzonen 18 alternieren, hier entlang der radialen Richtung. Die Schichtzonen 17, 18 erstrecken sich hier jeweils kreisbogenförmig, und dabei konzentrisch bezüglich des Mittelpunkts des Subelements 1.

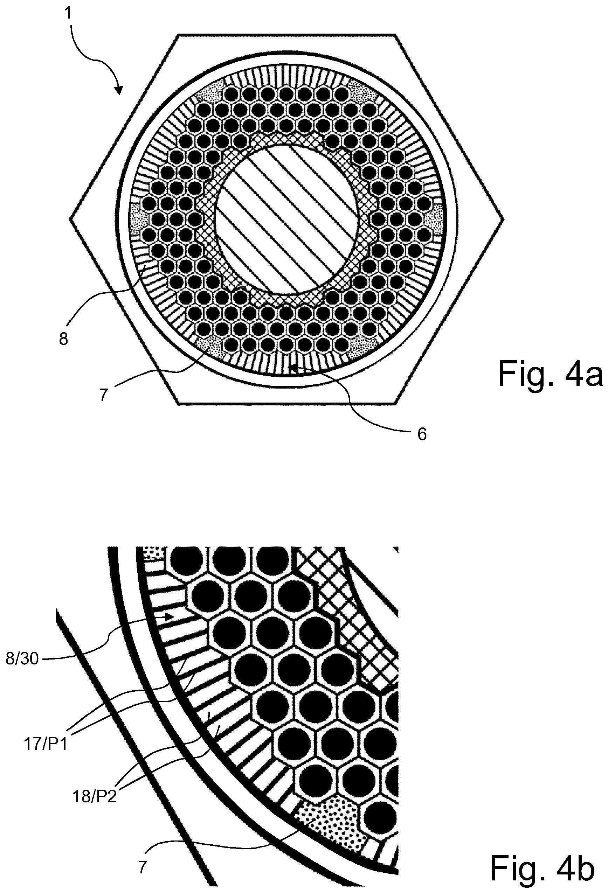

Die **Fig. 4a** in Gesamtüberblick und die **Fig. 4b** mit einem vergrößerten Ausschnitt aus Fig. 4a zeigen ebenfalls ein Subelement 1 in einer Ausführungsform, bei der zwei Typen von Nb-haltigen Füllelementen 7, 8 verbaut sind. Die kleineren Nb-haltigen Füllelemente 7 enthalten hier fein verteiltes Nb, hingegen weisen die größeren Nb-haltigen Füllelemente 8 wiederum eine Schichtstruktur 30 auf.

Die Schichtstruktur 30 wird gebildet durch mehrere erste Schichtzonen 17 einer ersten, niobhaltigen Phase P1 (zB aus reinem Nb), und mehreren zweiten Schichtzonen 18 einer zweiten, Cu-haltigen Phase P2 (zB reinem Cu). Die ersten Schichtzonen 17 und die zweiten Schichtzonen 18 alternieren, hier entlang der Umfangsrichtung. Die Schichtzonen 17, 18 erstrecken sich hier jeweils gerade entlang der radialen Richtung bezüglich des Mittelpunkts des Subelements 1.

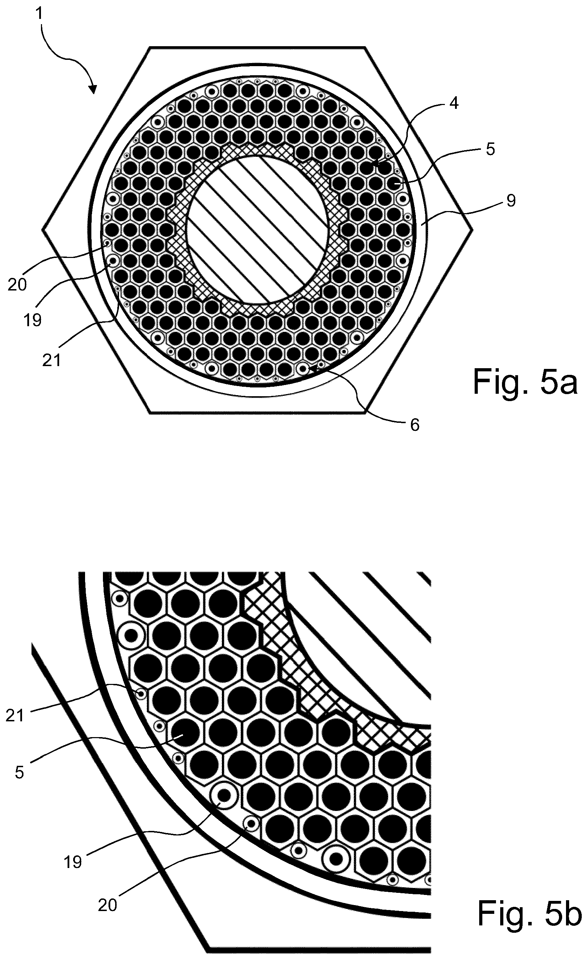

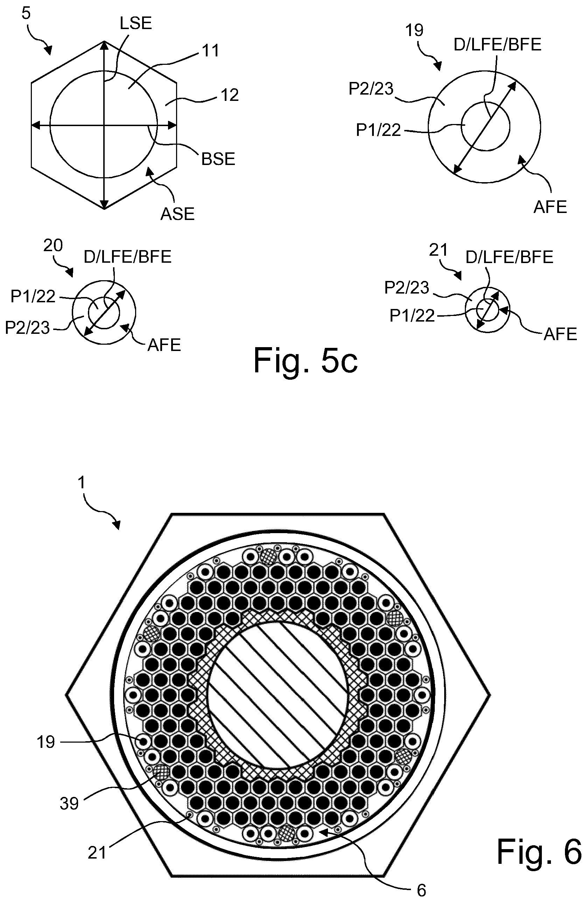

Die **Fig. 5a** in Gesamtüberblick und die **Fig. 5b** mit einem vergrößerten Ausschnitt aus Fig. 5a zeigen ein Subelement 1 in einer Ausführungsform, bei der hier drei Typen von Nb-haltigen Füllelementen 19, 20, 21 im Zwischenbereich 6 verbaut sind. Die **Fig.5c** zeigt zusätzlich aus Fig. 5a die Nb-haltigen Füllelemente 19, 20, 21 und ein Nb-haltiges Stabelement 5 einzeln und vergrößert, aber zueinander maßstabsgetreu.

In der gezeigten Bauform ist der Zwischenbereich 6 zwischen dem Bündelbereich 4 und der Diffusionsbarriere 9 vergleichsweise schmal, so dass im Zwischenbereich 6 keine weiteren Nb-haltigen Stabelemente 5 mehr angeordnet werden könnten.

Die Nb-haltigen Füllelemente 19, 20, 21 sind jeweils im außenquerschnitt kreisrund ausgebildet, weisen aber eine unterschiedliche Größe auf. Das Nb-haltige Füllelement 19 hat den größten Durchmesser D, das Nb-haltige Füllelement 20 hat einen mittleren Durchmesser D, und das Nb-haltige Füllelement 21 hat den kleinsten Durchmesser D. Alle drei Typen von Nb-haltigen Füllelementen 19, 20, 21 weisen jeweils eine Kernzone 22 einer ersten, Nb-haltigen Phase P1, und eine Kaschierzone 23 einer zweiten, Cu-haltigen Phase P2 auf. Die Kaschierzone 23 umschließt allseitig (vollständig über den gesamten Umfang) die Kernzone 22.

Die Nb-haltigen Füllelemente 19, 20, 21 sind hier bei allen drei Typen im Vergleich zum Nb-haltigen Stabelement 5 bezüglich verschiedener Aspekte kleiner ausgebildet:
Die Querschnittsfläche ASE des Nb-haltigen Stabelements 5 ist größer als die jeweilige Querschnittsfläche AFE der Nb-haltigen Füllelemente 19, 20, 21.

Weiterhin ist die größte Länge LSE des Nb-haltigen Stabelements 5 (zwischen zwei gegenüberliegenden Ecken) größer als die jeweilige größte Länge LFE der Nb-haltigen Füllelemente 19, 20, 21. Man beachte, dass aufgrund der kreisrunden Form LFE hier jeweils D entspricht.

Zudem ist die größte Breite BSE senkrecht zur Richtung der größten Länge LSE beim Nb-haltigen Stabelement 5 (zwischen zwei gegenüberliegenden Seiten) größer ist als die größte Breite BFE senkrecht zur Richtung der größten Länge LFE beim jeweiligen Nb-haltigen Füllelement 19, 20, 21. Man beachte, dass aufgrund der kreisrunden Form BFE hier ebenfalls jeweils D entspricht.

Aufgrund dieser Aspekte kann mit den Nb-haltigen Füllelementen 19, 20, 21 der Zwischenbereich 6 zu einem hohen Grad befüllt werden, auch wenn Nb-haltige Stabelemente 5 dort nicht mehr anordenbar sind.

Die **Fig. 6** zeigt eine Ausführungsform eine Subelementes 1, bei dem im Zwischenbereich 6 zwei Typen von runden Nb-haltigen Füllelementen 19, 21 unterschiedlicher Größe verbaut sind. Die Nb-haltigen Füllelemente 19 sind größer als die Nb-haltigen Füllelemente 21. Die Nb-haltigen Füllelemente 19, 21 verfügen hier jeweils über einen Nb-Kern und eine Cu-Kaschierung (vgl. Fig. 5c hierzu).

Weiterhin enthält der Zwischenbereich 6 hier auch Verstärkungs-Zusatzelemente 39 von runder Form. Diese sind beispielsweise aus reinem Tantal gefertigt. In der gezeigten Ausführungsform sind die Verstärkungs-Zusatzelemente 39 gleich groß wie die Nb-haltigen Füllelemente 19. Die Verstärkungs-Zusatzelemente könnten jedoch auch zweikomponentig hergestellt sein, z. B. als Cu-kaschierte Ta-Elemente (nicht dargestellt).

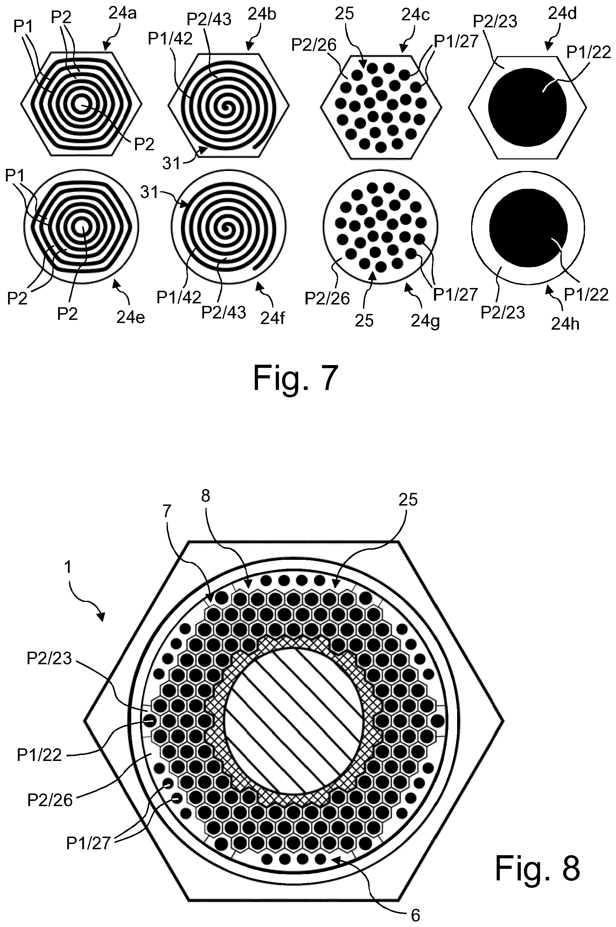

Die **Fig. 7** zeigt verschiedene Typen von Nb-haltigen Füllelementen 24a-24h im schematischen Querschnitt, die in einem erfindungsgemäßen Subelement verbaut werden können. Allen diesen Nb-haltigen Füllelementen 24a-24h der Fig. 7 ist gemeinsam, dass sie jeweils wenigstens eine Zone einer ersten, Nb-haltigen Phase P1 aufweisen, und wenigstens eine Zone einer zweiten, Cu-haltigen Phase P2 aufweisen. Die Nb-haltigen Füllelemente 24a-24d sind jeweils außen hexagonal ausgebildet, und die Nb-haltigen Füllelemente 24e-24h sind jeweils außen kreisrund ausgebildet.

Die Nb-haltigen Füllelemente 24a, 24e weisen mehrere (hier fünf) ringförmige Zonen der Nb-haltigen Phase P1 auf, und zu diesen alternierend mehrere (hier sechs) ringförmige Zonen der Cu-haltigen Phase P2 auf, wobei diese Zonen der Phasen P1, P2 zueinander konzentrisch (bezüglich des Nb-haltigen Füllelements 24a, 24e) angeordnet sind. In der Mitte des Nb-haltigen Füllelements 24a, 24e ist eine weitere Zone der zweiten, Cu-haltigen Phase P2 angeordnet.

Die Nb-haltigen Füllelemente 24b, 24f weisen jeweils eine Schichtzone 42 der ersten, Nb-haltigen Phase P1 und eine aufgerollte Schichtzone 43 der zweiten, Cu-haltigen Phase P2 auf, wobei diese nach Art einer Schnecke zusammen aufgerollt sind. Die Schichtzonen 42, 43 bilden eine aufgerollte Struktur 31 ("jelly-roll"-Aufbau).

Die Nb-haltigen Füllelemente 24c, 24g weisen eine Multifilament-Struktur 25 auf, wobei die zweite Cu-haltige Phase P2 eine Matrixzone 26 ausbildet, und die erste Nb-haltige Phase P1 mehrere Filamentzonen 27 (hier neunundzwanzig Filamentzonen) ausbildet, die in der Matrixzone 26 verteilt angeordnet sind. Die Filamentzonen 27 sind durch die Matrixzone 26 voneinander getrennt.

Die Nb-haltigen Füllelemente 24d, 24h weisen jeweils radial innen eine Zone der ersten, Nb-haltigen Phase P1 als Kernzone 22 auf, und radial außen eine Zone der zweiten, Cu-haltigen Phase P2 als Kaschierzone 23 auf. Die Kernzone 22 ist hier im Außenquerschnitt kreisrund ausgebildet.

Die **Fig. 8** zeigt eine Ausführungsform eines Subelements 1, bei dem im Zwischenbereich 6 zwei Typen von runden Nb-haltigen Füllelementen 7, 8 unterschiedlicher Größe verbaut sind.

Die kleineren Nb-haltigen Füllelemente 7 weisen jeweils eine einzelne Zone der ersten, Nb-haltigen Phase P1 auf, und eine umgebende Zone der zweiten, Cu-haltigen Phase P2. Die Phase P1 kann hierbei einer Kernzone 22 zugeordnet werden, und die Phase P2 einer Kaschierzone 23. Die Phase P2 in der Kaschierzone 23 ist hier als eine CuSn-Legierung gewählt.

Die größeren Nb-haltigen Füllelemente 8 weisen jeweils mehrere (hier vier) Zonen der ersten, Nb-haltigen Phase P1 auf, und eine umgebende Zone der zweiten, Cu-haltigen Phase P2. Die Zonen der Phasen P1 bilden hier Filamentzonen 27, und die Zone der Phase P2 bildet hier eine Matrixzone 26, entsprechend einer Multifilament-Struktur 25. Die Phase P2 in der Matrixzone 26 ist hier ebenfalls als eine CuSn-Legierung gewählt.

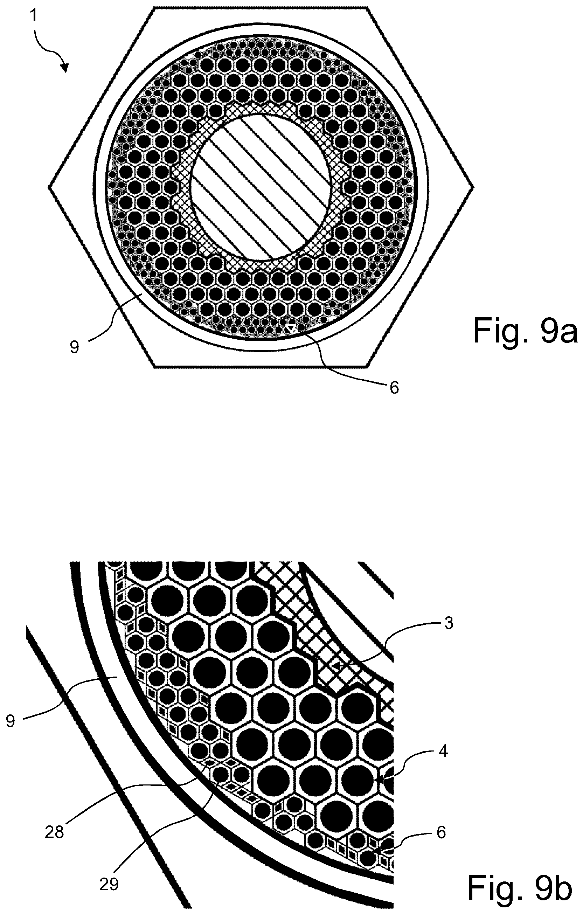

Die **Fig. 9a** im Gesamtüberblick und die **Fig. 9b** mit einem vergrößerten Ausschnitt aus Fig. 9a zeigen ein Subelement 1 in einer Ausführungsform, bei der zwei Typen von Nb-haltigen Füllelementen 28, 29 im Zwischenbereich 6 verbaut sind.

Die kleineren Nb-haltigen Füllelemente 28 sind außen rautenförmig ausgebildet, und die größeren Nb-haltigen Füllelemente 29 sind außen hexagonal ausgebildet. Die Entfernung zwischen zwei benachbarten Ecken ist in beiden Typen der Nb-haltigen Füllelemente 28, 29 gleich.

Durch Kombination der beiden Typen von Nb-haltigen Füllelementen 28, 29 kann ein sehr hoher, insbesondere maximaler, Befüllungsgrad des Zwischenbereichs 6 zwischen dem Bündelbereich 4 und der Diffusionsbarriere 9 erreicht werden.

Beide Typen von Nb-haltigen Füllelementen 28, 29 weisen hier in der Mitte eine Zone einer ersten, Nb-haltigen Phase auf, und eine umgebende Zone einer zweiten, Cu-haltigen Phase.

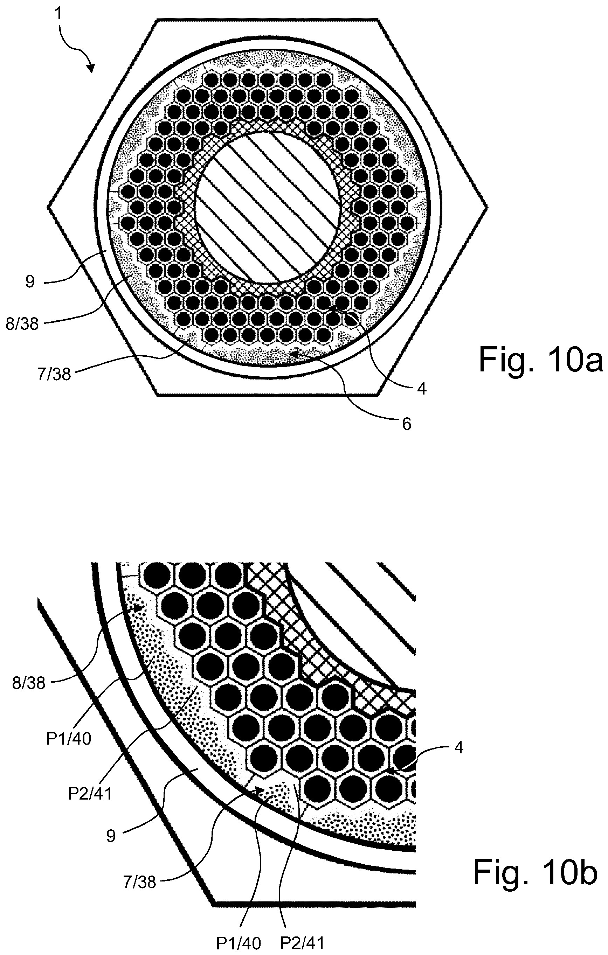

Die **Fig. 10a** im Gesamtüberblick und die **Fig. 10b** mit einem vergrößerten Ausschnitt aus Fig. 10a zeigen ein Subelement 1 in einer Ausführungsform, bei der zwei Typen von Nb-haltigen Füllelementen 7, 8 im Zwischenbereich 6 verbaut sind.

Die Nb-haltigen Füllelemente 7, 8 umfassen jeweils eine hintere Zone 40 einer ersten, Nb-haltigen Phase P1, und eine vordere Zone 41 einer zweiten, Cu-haltigen Phase P2.

Die vordere Zone 41 liegt von der Mitte des Subelementes 1 aus gesehen vor der hinteren Zone 40. Die vordere Zone 41 grenzt vorne/radial innen an den Bündelbereich 4. Die hintere Zone 40 grenzt hinten/radial außen an die Diffusionsbarriere 9, nicht aber an den Bündelbereich 4.

In der gezeigten Bauform reicht die vordere Zone 41 zudem auch seitlich um die hinteren Zonen 40 näherungsweise U-förmig herum, bis an die Diffusionsbarriere 9.

In der zeigten Bauform enthält die Nb-haltige Phase P1 in der jeweils hinteren Zone 40 auch einen Anteil an Titan, beispielsweise in einer Legierung Nb0.5Ti. Dadurch fungieren die Nb-haltigen Füllelemente 8 gleichzeitig als Dotier-Füllelemente 38.

Die **Fig. 11** illustriert den zeitlichen Ablauf bei der Fertigung eines Nb₃Sn-Supraleiterdrahts 32 im Rahmen der Erfindung. Zu den verschiedenen Fertigungsschritten sind schematische Teilbilder in zeitlicher Reihenfolge von t1 bis t6 angegeben.

Zunächst wird im Schritt t1 eine Vielzahl von Subelementen 1 gefertigt; typische Subelemente 1 sind in den vorhergehenden Figuren erläutert.

In einem Schritt t2 werden anschließend die Subelemente 1 einer querschnittsreduzierenden Umformung unterzogen, beispielsweise einem Ziehprozess oder einem Extrudierprozess. Dadurch wird ein verjüngtes Subelement 1' erhalten.

In einem Schritt t3 werden nun mehrere verjüngte Subelemente 1' gebündelt und in einem Hüllrohr 33 angeordnet. Das Hüllrohr 33 ist typischerweise aus Cu gefertigt. Dadurch wird ein Halbzeugdraht 34 erhalten.

Im nachfolgenden Schritt t4 wird der Halbzeugdraht 34 einer querschnittsreduzierenden Umformung unterzogen, beispielsweise einem Ziehprozess oder einem Extrudierprozess. Dadurch wird ein verjüngter Halbzeugdraht 34' erhalten. Falls gewünscht, kann mit dem verjüngten Halbzeugdraht eine weitere Bündelungs- und Verjüngungsiteration vorgenommen werden (nicht näher dargestellt). Der verjüngte Halbzeugdraht 34' hat am Ende von Schritt t4 den für die Anwendung gewünschten Durchmesser.

Der verjüngte Halbzeugdraht 34' wird nun in Schritt t5 in die für die Anwendung gewünschte Form gebracht. Im gezeigten Beispiel wird der verjüngte Halbzeugdraht 34' auf einem Spulenkörper 35 zu einer Spule gewickelt. Man beachte, dass der verjüngte Halbzeugdraht 34'vor der Reaktionswärmebehandlung noch gut elastisch und plastisch verformbar ist.

In einem Schritt t6 wird schließlich in einem Ofen 36 der der verjüngte Halbzeugdraht einer Reaktionswärmebehandlung unterzogen. Dabei reagiert enthaltenes Nb mit enthaltenem Sn zu Nb₃Sn. Der bisherige verjüngte Halbzeugdraht wird dadurch zum fertigen Nb₃Sn-Supralkeiterdraht 32. Im gezeigten Beispiel ist damit eine supraleitende Magnetspule 37 fertiggestellt. Man beachte, dass das Nb₃Sn im fertigen Halbzeugdraht vergleichsweise spröde ist, und daher nicht mehr verformt werden sollte.

### Bezugszeichenliste

- 1: (noch nicht verjüngtes) Subelement
- 1': verjüngtes Subelement
- 2: Sn-haltiger Kernbereich
- 3: Cu-haltiger innerer Matrixbereich
- 4: Bündelbereich
- 5: Nb-haltiges Stabelement
- 6: Zwischenbereich
- 7: Nb-haltiges Füllelement (radial innen abschnittweise gerade profiliert, radial außen rund profiliert, klein)
- 8: Nb-haltiges Füllelement (radial innen abschnittweise gerade profiliert, radial außen rund profiliert, groß)
- 9: Diffusionsbarriere
- 10: Cu-haltiger Hüllbereich
- 11: Nb-Kern
- 12: Cu-Hülle
- 13: abschnittweise gerade Profilierung
- 14: abschnittweise runde Profilierung
- 15: Verstärkungs-Füllelement
- 16: Dotier-Zusatzelement
- 17: erste Schichtzone (P1)
- 18: zweite Schichtzone (P2)
- 19: Nb-haltiges Füllelement (rund, groß)
- 20: Nb-haltiges Füllelement (rund, mittel)
- 21: Nb-haltiges Füllelement (rund, klein)
- 22: Kernzone (P1)
- 23: Kaschierzone (P2)
- 24a-24g: Nb-haltige Füllelemente (mit P1, P2)
- 25: Multifilament-Struktur
- 26: Matrixzone (P2)
- 27: Filamentzonen (P1)
- 28: Nb-haltiges Füllelement (polygonal, hier rautenförmig)
- 29: Nb-haltiges Füllelement (polygonal, hier sechseckförmig)
- 30: Schichtstruktur
- 31: aufgerollte Struktur
- 32: Nb₃Sn-Supraleiterdraht
- 33: Hüllrohr (für Halbzeugdraht)
- 34: (noch nicht verjüngter) Halbzeugdraht
- 34': verjüngter Halbzeugdraht
- 35: Spulenkörper
- 36: Ofen
- 37: supraleitende Magnetspule
- 38: Dotier-Füllelement
- 39: Verstärkungs-Zusatzelement
- 40: hintere Zone
- 41: vordere Zone
- 42: aufgerollte Schichtzone (P1)
- 43: aufgerollte Schichtzone (P2)
- AFE: Querschnittsfläche Nb-haltiges Füllelement
- ASE: Querschnittsfläche Nb-haltiges Stabelement
- AVFE: Aspektverhältnis Nb-haltiges Füllelement
- AVSE: Aspektverhältnis Nb-haltiges Stabelement
- BFE: größte Breite Nb-haltiges Füllelement (senkrecht zur Richtung von LFE)
- BSE: größte Breite Nb-haltiges Stabelement (senkrecht zur Richtung von LSE)
- D: (äußerer) Durchmesser
- LFE: größte Länge Nb-haltiges Füllelement
- LSE: größte Länge Nb-haltiges Stabelement
- P1: erste, Nb-haltige Phase
- P2: zweite, Cu-haltigen Phase
- t1-t6: Schritte (Teilschritte) im Herstellungsprozess des Nb₃Sn-Supraleiterdrahts

## Patentansprüche

1. Subelement (1) für einen Halbzeugdraht (34) zur Herstellung eines Nb₃Sn-Supraleiterdrahts (32),
wobei das Subelement (1) umfasst
- einen Sn-haltigen Kernbereich (2),
- einen Cu-haltigen, inneren Matrixbereich (3), der den Sn-haltigen Kernbereich (2) umgibt,
- einen Bündelbereich (4), umfassend eine Vielzahl von aneinander anliegenden Nb-haltigen Stabelementen (5), wobei der Bündelbereich (4) den inneren Matrixbereich (3) umgibt,
- einen Zwischenbereich (6), der den Bündelbereich (4) umgibt,
- eine umlaufende Diffusionsbarriere (9), die den Zwischenbereich (6) umgibt, und
- einen Cu-haltigen Hüllbereich (10), der die Diffusionsbarriere (9) umgibt,
**dadurch gekennzeichnet,**
**dass** im Zwischenbereich (6) Nb-haltige Füllelemente (7, 8; 19, 20, 21; 24a-24h; 28, 29) angeordnet sind, welche jeweils eine Geometrie haben, die sich von der Geometrie der Nb-haltigen Stabelemente (5) unterscheidet.

2. Subelement (1) nach Anspruch 1, **dadurch gekennzeichnet, dass** die Nb-haltigen Stabelemente (5) einen hexagonalen Querschnitt aufweisen.

3. Subelement (1) nach Anspruch 1 oder 2, **dadurch gekennzeichnet, dass** die Nb-haltigen Stabelemente (5) jeweils eine Querschnittsfläche ASE aufweisen, und dass zumindest ein Teil der Nb-haltigen Füllelemente (19, 20, 21; 24a-24h; 28, 29) jeweils eine Querschnittsfläche AFE aufweist, mit AFE<ASE.

4. Subelement (1) nach einem der vorhergehenden Ansprüche, **dadurch gekennzeichnet,**
**dass** die Nb-haltigen Stabelemente (5) im Querschnitt jeweils eine größte Länge LSE aufweisen, und zumindest ein Teil der Nb-haltigen Füllelemente (19, 20, 21; 24a-24h; 28, 29) im Querschnitt jeweils eine größte Länge LFE aufweist, mit LFE<LSE,
und/oder
**dass** die Nb-haltigen Stabelemente (5) im Querschnitt jeweils eine größte Breite BSE senkrecht zur Richtung ihrer größten Länge LSE aufweisen, und zumindest ein Teil der Nb-haltigen Füllelemente (19, 20, 21; 24a-24h; 28, 29) im Querschnitt jeweils eine größte Breite BFE senkrecht zur Richtung ihrer größten Länge LFE aufweist, mit BFE<BSE.

5. Subelement (1) nach einem der vorhergehenden Ansprüche, **dadurch gekennzeichnet, dass** die Nb-haltigen Stabelemente (5) im Querschnitt jeweils eine Aspektverhältnis AVSE aufweisen, und dass zumindest ein Teil der Nb-haltigen Füllelemente (7, 8; 28) im Querschnitt jeweils eine Aspektverhältnis AVFE aufweist, mit AVFE>AVSE.

6. Subelement (1) nach einem der vorhergehenden Ansprüche, **dadurch gekennzeichnet, dass** im Zwischenbereich (6) Nb-haltige Füllelemente (7, 8; 19, 20, 21; 24a-24h; 28, 29) von wenigstens zwei verschiedenen Typen angeordnet sind, wobei sich die verschiedenen Typen der Nb-haltigen Füllelemente (7, 8; 19, 20, 21; 24a-24h; 28, 29) zumindest in ihrer Geometrie unterscheiden.

7. Subelement (1) nach einem der vorhergehenden Ansprüche, **dadurch gekennzeichnet, dass** zumindest ein Teil der Nb-haltigen Füllelemente (19, 20, 21; 24e-24h) im Querschnitt außen kreisrund ausgebildet ist.

8. Subelement (1) nach einem der vorhergehenden Ansprüche, **dadurch gekennzeichnet, dass** zumindest ein Teil der Nb-haltigen Füllelemente (28, 29) im Querschnitt außen polygonal, insbesondere hexagonal, ausgebildet ist.

9. Subelement (1) nach einem der vorhergehenden Ansprüche, **dadurch gekennzeichnet, dass** zumindest bei einem Teil der Nb-haltigen Füllelemente (7, 8) ein jeweiliges Füllelement im Querschnitt
- an einer radial innen liegenden Seite eine Profilierung (13) entsprechend einem Teilstück eines äußeren Randes des Bündelbereichs (4) aufweist, und
- an einer radial äußeren Seite eine runde Profilierung (14) entsprechend einem Teilstück der Innenseite der Diffusionsbarriere (9) aufweist.

10. Subelement (1) nach einem der vorhergehenden Ansprüche, **dadurch gekennzeichnet, dass** zumindest ein Teil der Nb-haltigen Füllelemente (7, 8; 19, 20, 21; 24a-24h; 28, 29) weiterhin Cu-haltig ist.

11. Subelement (1) nach einem der vorhergehenden Ansprüche, **dadurch gekennzeichnet, dass** zumindest bei einem Teil der Nb-haltigen Füllelemente (7, 8; 19, 20, 21; 24a-24h; 28, 29) ein jeweiliges Füllelement (7, 8; 19, 20, 21; 24a-24h; 28, 29) im Querschnitt
- zumindest eine Zone einer ersten, Nb-haltige Phase (P1) aufweist, und
- zumindest eine Zone einer zweiten, Cu-haltige Phase (P2) aufweist.

12. Subelement (1) nach Anspruch 11, **dadurch gekennzeichnet, dass** zumindest bei einem Teil der Nb-haltigen Füllelemente (7, 8; 19, 20, 21; 24a-24h; 28, 29) ein jeweiliges Füllelement (7, 8; 19, 20, 21; 24a-24h; 28, 29) im Querschnitt
- eine Kernzone (22) der ersten, Nb-haltigen Phase (P1) aufweist, und
- eine Kaschierzone (23) der zweiten, Cu-haltigen Phase (P2) aufweist, welche die Kernzone (22) vollständig umschließt.

13. Subelement (1) nach einem der Ansprüche 11 oder 12, **dadurch gekennzeichnet, dass** zumindest bei einem Teil der Nb-haltigen Füllelemente (7, 8; 19, 20, 21; 24a-24h; 28, 29) ein jeweiliges Füllelement (7, 8; 19, 20, 21; 24a-24h; 28, 29) im Querschnitt
- eine hintere Zone (40) der ersten, Nb-haltigen Phase (P1) aufweist, welche radial außen an die Diffusionsbarriere (9) angrenzt, und
- eine vordere Zone (41) der zweiten, Cu-haltigen Phase (P2) aufweist, welche radial innen an den Bündelbereich (4) angrenzt und die hintere Zone (40) vom Bündelbereich (4) abtrennt.

14. Subelement (1) nach einem der Ansprüche 11 bis 13, **dadurch gekennzeichnet, dass** zumindest bei einem Teil der Nb-haltigen Füllelemente (7, 8; 19, 20, 21; 24a-24h; 28, 29) ein jeweiliges Füllelement (7, 8; 19, 20, 21; 24a-24h; 28, 29) im Querschnitt
- als Schichtstruktur (30) mit mehreren ersten Schichtzonen (17) der ersten, Nb-haltigen Phase (P1) und mehreren zweite Schichtzonen (18) der zweiten, Cu-haltigen Phase (P2) ausgebildet ist,
- und erste Schichtzonen (17) und zweite Schichtzonen (18) alternieren.

15. Subelement (1) nach einem der Ansprüche 11 bis 14, **dadurch gekennzeichnet, dass** zumindest bei einem Teil der Nb-haltigen Füllelemente (7, 8; 19, 20, 21; 24a-24h; 28, 29) ein jeweiliges Füllelement (7, 8; 19, 20, 21; 24a-24h; 28, 29) im Querschnitt
- als aufgerollte Struktur (31) mit einer aufgerollten Schichtzone (42) der ersten, Nb-haltigen Phase (P1) und einer aufgerollten Schichtzone (43) der zweiten, Cu-haltigen Phase (P2) ausgebildet ist, wobei diese aufgerollten Schichtzonen (42, 43) zusammen aufeinander gerollt sind, und/oder
- als Multifilament-Struktur (25) mit einer Matrixzone (26) der zweiten, Cu-haltigen Phase (P2) und mehreren Filamentzonen (27) der ersten, Nb-haltigen Phase (P1), die in der Matrixzone (26) verteilt angeordnet sind, ausgebildet ist.

16. Subelement (1) nach einem der Ansprüche 11 bis 15, **dadurch gekennzeichnet, dass** zumindest bei einem Teil der Nb-haltigen Füllelemente (7, 8; 19, 20, 21; 24a-24h; 28, 29) eine oder mehrere Zonen der ersten, Nb-haltigen Phase (P1) und ein oder mehrere Zonen der zweiten, Cu-haltigen Phase (P2) konzentrisch im Nb-haltigen Füllelement (7, 8; 19, 20, 21; 24a-24h; 28, 29) angeordnet sind.

17. Subelement (1) nach einem der vorhergehenden Ansprüche, **dadurch gekennzeichnet,**
**dass** zumindest ein Teil der Nb-haltigen Füllelemente (7, 8; 19, 20, 21; 24a-24h; 28, 29) als Dotier-Füllelemente (38) ausgebildet sind, wobei die Dotier-Füllelemente (38) in zumindest einer enthaltenen Phase (P1, P2) wenigstens ein Element der vierten Nebengruppe des Periodensystems enthalten,
und/oder
**dass** im Zwischen-Bereich (6) auch Dotier-Zusatzelemente (16) angeordnet sind, wobei die Dotier-Zusatzelemente (16) in zumindest einer enthaltenen Phase (P1, P2) wenigstens ein Element der vierten Nebengruppe des Periodensystems enthalten,
insbesondere wobei das wenigstens eine Element der vierten Nebengruppe des Periodensystems Titan umfasst.

18. Subelement (1) nach einem der vorhergehenden Ansprüche, **dadurch gekennzeichnet,**
**dass** zumindest ein Teil der Nb-haltigen Füllelemente (7, 8; 19, 20, 21; 24a-24h; 28, 29) als Verstärkungs-Füllelemente (15) ausgebildet sind, wobei die Verstärkungs-Füllelemente (15) in zumindest einer enthaltenen Phase (P1, P2) wenigstens ein Element der fünften Nebengruppe des Periodensystems enthalten,
und/oder
**dass** im Zwischen-Bereich (6) auch Verstärkungs-Zusatzelemente (39) angeordnet sind, wobei die Verstärkungs-Zusatzelemente (39) in zumindest einer enthaltenen Phase (P1, P2) wenigstens ein Element der fünften Nebengruppe des Periodensystems enthalten,
insbesondere wobei das wenigstens eine Element der fünften Nebengruppe des Periodensystems Tantal umfasst.

19. Subelement (1) nach einem der vorhergehenden Ansprüche, **dadurch gekennzeichnet, dass** zumindest bei einem Teil der Nb-haltigen Füllelemente (7, 8; 19, 20, 21; 24a-24h; 28, 29) das jeweilige Füllelement (7, 8; 19, 20, 21; 24a-24h; 28, 29)
- weiterhin auch Sn enthält,
- bevorzugt wobei das jeweilige Füllelement (7, 8; 19, 20, 21; 24a-24h; 28, 29) im Querschnitt zumindest eine Zone einer ersten, Nb-haltigen Phase (P1) und zumindest eine Zone einer zweiten, Cu-haltigen Phase (P2) aufweist, und das Sn in der Cu-haltigen Phase (P2) enthalten ist,
- besonders bevorzugt wobei eine Kernzone (22) der ersten, Nb-haltigen Phase (P1) von einer Kaschierzone (23) der zweiten, Cu-haltigen Phase (P2), in der auch das Sn enthalten ist, vollständig umschlossen ist.

20. Verfahren zur Herstellung eines Nb₃Sn-Supraleiterdrahts (32), umfassend zumindest folgende Schritte:
Schritt 1) Fertigung (t1, t2) mehrerer Subelemente (1; 1') gemäß einem der vorhergehenden Ansprüche;
Schritt 2) Bündelung (t3, t4) mehrerer gefertigter Subelemente (1; 1') zu einem Halbzeugdraht (34; 34');
Schritt 3) Reaktionswärmebehandlung (t5, t6) des Halbzeugdrahts (34; 34'), wobei Sn und Nb aus dem Halbzeugdraht (34; 34') zu Nb₃Sn reagieren.

## Claims

1. Subelement (1) for a semi-finished wire (34) for producing a Nb₃Sn superconducting wire (32),
wherein the subelement (1) comprises
- a Sn-containing core region (2),
- a Cu-containing inner matrix region (3) surrounding the Sn-containing core region (2),
- a bundle region (4) comprising a plurality of adjacent and touching, Nb-containing rod elements (5), wherein the bundle region (4) surrounds the inner matrix region (3),
- an intermediate region (6) surrounding the bundle region (4),
- a circumferential diffusion barrier (9) surrounding the intermediate region (6), and
- a Cu-containing sheath region (10) surrounding the diffusion barrier (9),
**characterized in that**
Nb-containing filling elements (7, 8; 19, 20, 21; 24a-24h; 28, 29) are arranged in the intermediate region (6), each of which has a geometry that differs from the geometry of the Nb-containing rod elements (5).

2. Subelement (1) according to claim 1, **characterized in that** the Nb-containing rod elements (5) have a hexagonal cross-section.

3. Subelement (1) according to claim 1 or 2, **characterized in that** the Nb-containing rod elements (5) each have a cross-sectional area ASE, and **in that** at least some of the Nb-containing filling elements (19, 20, 21; 24a-24h; 28, 29) each have a cross-sectional area AFE, where AFE<ASE.

4. Subelement (1) according to one of the preceding claims, **characterized in that**
the Nb-containing rod elements (5) in cross-section each have a maximum length LSE, and at least some of the Nb-containing filling elements (19, 20, 21; 24a-24h; 28, 29) each have a maximum length LFE in cross-section, where LFE<LSE,
and/or
the Nb-containing rod elements (5) in cross-section each have a maximum width BSE perpendicular to the direction of their maximum length LSE, and at least some of the Nb-containing filling elements (19, 20, 21; 24a-24h; 28, 29) in cross-section each have a maximum width BFE perpendicular to the direction of their maximum length LFE, where BFE<BSE.

5. Subelement (1) according to one of the preceding claims, **characterized in that** the Nb-containing rod elements (5) in cross-section each have an aspect ratio AVSE, and **in that** at least some of the Nb-containing filling elements (7, 8; 28) each have an aspect ratio AVFE in cross-section, where AVFE>AVSE.

6. Subelement (1) according to one of the preceding claims, **characterized in that** Nb-containing filling elements (7, 8; 19, 20, 21; 24a-24h; 28, 29) of at least two different types are arranged in the intermediate region (6), wherein the different types of Nb-containing filling elements (7, 8; 19, 20, 21; 24a-24h; 28, 29) differ at least in their geometry.

7. Subelement (1) according to one of the preceding claims, **characterized in that** at least some of the Nb-containing filling elements (19, 20, 21; 24e-24h) are circular in cross-section on the outside.

8. Subelement (1) according to one of the preceding claims, **characterized in that** at least some of the Nb-containing filling elements (28, 29) are polygonal in cross-section on the outside, in particular hexagonal.

9. Subelement (1) according to one of the preceding claims, **characterized in that**, for at least some of the Nb-containing filling elements (7, 8), each filling element, in cross-section
- on a radially inner side has a profile (13), corresponding to a portion of an outer edge of the bundle region (4), and
- on a radially outer side has a round profile (14), corresponding to a portion of the inner side of the diffusion barrier (9).

10. Subelement (1) according to one of the preceding claims, **characterized in that** at least some of the Nb-containing filling elements (7, 8; 19, 20, 21; 24a-24h; 28, 29) also contain Cu.

11. Subelement (1) according to one of the preceding claims, **characterized in that**, for at least some of the Nb-containing filling elements (7, 8; 19, 20, 21; 24a-24h; 28, 29), each filling element (7, 8; 19, 20, 21; 24a-24h; 28, 29), in cross-section
- has at least one zone of a first, Nb-containing, phase (P1), and
- has at least one zone of a second, Cu-containing, phase (P2).

12. Subelement (1) according to claim 11, **characterized in that**, for at least some of the Nb-containing filling elements (7, 8; 19, 20, 21; 24a-24h; 28, 29), each filling element (7, 8; 19, 20, 21; 24a-24h; 28, 29), in cross-section
- has a core zone (22) of the first, Nb-containing, phase (P1), and
- has a cladding zone (23) of the second, Cu-containing, phase (P2), which completely encloses the core zone (22).

13. Subelement (1) according to one of claims 11 or 12, **characterized in that**, for at least some of the Nb-containing filling elements (7, 8; 19, 20, 21; 24a-24h; 28, 29), each filling element (7, 8; 19, 20, 21; 24a-24h; 28, 29), in cross-section
- has a rear zone (40) of the first, Nb-containing, phase (P1), which rear zone borders radially outwards on the diffusion barrier (9), and
- has a front zone (41) of the second, Cu-containing, phase (P2), which front zone borders radially inwards on the bundle region (4) and separates the rear zone (40) from the bundle region (4).

14. Subelement (1) according to one of claims 11 to 13, **characterized in that**, for at least some of the Nb-containing filling elements (7, 8; 19, 20, 21; 24a-24h; 28, 29), each filling element (7, 8; 19, 20, 21; 24a-24h; 28, 29), in cross-section
- is formed as a layer structure (30) with multiple first layer zones (17) of the first, Nb-containing, phase (P1) and multiple second layer zones (18) of the second, Cu-containing, phase (P2),
- and first layer zones (17) and second layer zones (18) alternate.

15. Subelement (1) according to one of claims 11 to 14, **characterized in that**, for at least some of the Nb-containing filling elements (7, 8; 19, 20, 21; 24a-24h; 28, 29), each filling element (7, 8; 19, 20, 21; 24a-24h; 28, 29), in cross-section
- is formed as a rolled-up structure (31) with a rolled-up layer zone (42) of the first, Nb-containing, phase (P1) and a rolled-up layer zone (43) of the second, Cu-containing, phase (P2), wherein these rolled-up layer zones (42, 43) are rolled together on top of one another, and/or
- is formed as a multifilament structure (25) with a matrix zone (26) of the second, Cu-containing, phase (P2) and several filament zones (27) of the first, Nb-containing, phase (P1), which are distributed in the matrix zone (26).

16. Subelement (1) according to one of claims 11 to 15, **characterized in that**, for at least some of the Nb-containing filling elements (7, 8; 19, 20, 21; 24a-24h; 28, 29), one or more zones of the first, Nb-containing, phase (P1) and one or more zones of the second, Cu-containing, phase (P2) are arranged concentrically in the Nb-containing filling element (7, 8; 19, 20, 21; 24a-24h; 28, 29).

17. Subelement (1) according to one of the preceding claims, **characterized in that**
at least some of the Nb-containing filling elements (7, 8; 19, 20, 21; 24a-24h; 28, 29) are designed as doping filling elements (38), wherein, in at least one phase (P1, P2), the doping filling elements (38) contain at least one element of the fourth subgroup of the periodic table,
and/or
doping additional elements (16) are also arranged in the intermediate region (6), wherein, in at least one phase (P1, P2), the doping additional elements (16) contain at least one element of the fourth subgroup of the periodic table,
in particular wherein the at least one element of the fourth subgroup of the periodic table comprises titanium.

18. Subelement (1) according to one of the preceding claims, **characterized in that**
at least some of the Nb-containing filling elements (7, 8; 19, 20, 21; 24a-24h; 28, 29) are designed as reinforcing filling elements (15), wherein, in at least one phase (P1, P2), the reinforcing filling elements (15) contain at least one element of the fifth subgroup of the periodic table,
and/or
reinforcing additional elements (39) are also arranged in the intermediate region (6), wherein, in at least one phase (P1, P2), the reinforcing additional elements (39) contain at least one element of the fifth subgroup of the periodic table,
in particular wherein the at least one element of the fifth subgroup of the periodic table comprises tantalum.

19. Subelement (1) according to one of the preceding claims, **characterized in that**, for at least some of the Nb-containing filling elements (7, 8; 19, 20, 21; 24a-24h; 28, 29), each filling element (7, 8; 19, 20, 21; 24a-24h; 28, 29)
- also contains Sn,
- preferably wherein each filling element (7, 8; 19, 20, 21; 24a-24h; 28, 29) has in cross-section at least one zone of a first, Nb-containing, phase (P1) and at least one zone of a second, Cu-containing, phase (P2), and the Sn is contained in the Cu-containing phase (P2),
- particularly preferably wherein a core zone (22) of the first, Nb-containing, phase (P1) is completely enclosed by a cladding zone (23) of the second, Cu-containing, phase (P2), in which the Sn is also contained.

20. Method for producing a Nb₃Sn superconducting wire (32), comprising at least the following steps:
step 1) manufacturing (t1, t2) several subelements (1; 1') according to one of the preceding claims;
step 2) bundling (t3, t4) several manufactured subelements (1; 1') to form a semi-finished wire (34; 34');
step 3) reaction heat treatment (t5, t6) of the semi-finished wire (34; 34'), wherein Sn and Nb from the semi-finished wire (34; 34') react to make Nb₃Sn.

## Revendications

1. Sous-élément (1) pour un fil semi-fini (34) destiné à la fabrication d'un fil supraconducteur Nb₃Sn (32), le sous-élément (1) comprend
- une zone centrale contenant du Sn (2),
- une zone matricielle interne contenant du Cu (3), qui entoure la zone centrale contenant du Sn (2),
- une zone de faisceau (4), comprenant une pluralité d'éléments en barre contenant du Nb (5) adjacents, la zone de faisceau (4) entourant la zone matricielle interne (3),
- une zone intermédiaire (6), qui entoure la zone de faisceau (4),
- une barrière de diffusion (9) périphérique, qui entoure la zone intermédiaire (6), et
- une zone d'enveloppe contenant du Cu (10), qui entoure la barrière de diffusion (9),
**caractérisé en ce que** d
dans la zone intermédiaire (6) sont disposés des éléments de remplissage contenant du Nb (7, 8 ; 19, 20, 21 ; 24a-24h ; 28, 29), lesquels présentent chacun une géométrie différente de la géométrie des éléments en barre contenant du Nb (5).

2. Sous-élément (1) selon la revendication 1, **caractérisé en ce que** les éléments en barre contenant du Nb (5) présentent une section transversale hexagonale.

3. Sous-élément (1) selon la revendication 1 ou 2, **caractérisé en ce que** les éléments en barre contenant du Nb (5) présentent chacun une surface de section transversale ASE, et qu'au moins une partie des éléments de remplissage contenant du Nb (19, 20, 21; 24a-24h ; 28, 29) présentent chacun une surface de section transversale AFE, avec AFE<ASE.

4. Sous-élément (1) selon l'une des revendications précédentes, **caractérisé en ce que** les éléments en barre contenant du Nb (5) présentent chacun, en section transversale, une longueur maximale LSE, et qu'au moins une partie des éléments de remplissage contenant du Nb (19, 20, 21 ; 24a-24h ; 28, 29) présentent chacun, en section transversale, une longueur maximale LFE, avec LFE<LSE,
et/ou
**en ce que** les éléments en barre contenant du Nb (5) présentent chacun, en section transversale, une largeur maximale BSE perpendiculaire à la direction de leur longueur maximale LSE, et qu'au moins une partie des éléments de remplissage contenant du Nb (19, 20, 21 ; 24a-24h ; 28, 29) présentent chacun, en section transversale, une largeur maximale BFE perpendiculaire à la direction de leur longueur maximale LFE, avec BFE<BSE.

5. Sous-élément (1) selon l'une des revendications précédentes, **caractérisé en ce que** les éléments en barre contenant du Nb (5) présentent chacun, en section transversale, un rapport d'aspect AVSE, et qu'au moins une partie des éléments de remplissage contenant du Nb (7, 8 ; 28) présentent chacun, en section transversale, un rapport d'aspect AVFE, avec AVFE>AVSE.

6. Sous-élément (1) selon l'une des revendications précédentes, **caractérisé en ce que** dans la zone intermédiaire (6) sont disposés des éléments de remplissage contenant du Nb (7, 8 ; 19, 20, 21 ; 24a-24h ; 28, 29) de au moins deux types différents, les différents types d'éléments de remplissage contenant du Nb (7, 8 ; 19, 20, 21 ; 24a-24h ; 28, 29) se distinguant au moins par leur géométrie.

7. Sous-élément (1) selon l'une des revendications précédentes, **caractérisé en ce qu'**au moins une partie des éléments de remplissage contenant du Nb (19, 20, 21 ; 24e-24h) sont de forme circulaire extérieure en section transversale.

8. Sous-élément (1) selon l'une des revendications précédentes, **caractérisé en ce qu'**au moins une partie des éléments de remplissage contenant du Nb (28, 29) sont polygonaux, notamment hexagonaux, extérieurement en section transversale.

9. Sous-élément (1) selon l'une des revendications précédentes, **caractérisé en ce qu'**au moins pour une partie des éléments de remplissage contenant du Nb (7, 8), chaque élément de remplissage présente, en section transversale,
- sur un côté radialement interne, un profil (13) correspondant à une portion d'un bord externe de la zone de faisceau (4),
et -
sur un côté radialement externe, un profil arrondi (14) correspondant à une portion de la face interne de la barrière de diffusion (9).

10. Sous-élément (1) selon l'une des revendications précédentes, **caractérisé en ce qu'**au moins une partie des éléments de remplissage contenant du Nb (7, 8 ; 19, 20, 21 ; 24a-24h ; 28, 29) contient également du Cu.

11. Sous-élément (1) selon l'une des revendications précédentes, **caractérisé en ce qu'**au moins pour une partie des éléments de remplissage contenant du Nb (7, 8 ; 19, 20, 21 ; 24a-24h ; 28, 29), chaque élément de remplissage (7, 8 ; 19, 20, 21 ; 24a-24h ; 28, 29) présente, en section transversale,
- au moins une zone d'une première phase contenant du Nb (P1), et
- au moins une zone d'une deuxième phase contenant du Cu (P2).

12. Sous-élément (1) selon la revendication 11, **caractérisé en ce qu'**au moins pour une partie des éléments de remplissage contenant du Nb (7, 8 ; 19, 20, 21 ; 24a-24h ; 28, 29), chaque élément de remplissage (7, 8 ; 19, 20, 21 ; 24a-24h ; 28, 29) présente, en section transversale
- une zone centrale (22) de la première phase contenant du Nb (P1), et
- une zone d'enrobage (23) de la deuxième phase contenant du Cu (P2), qui entoure complètement la zone centrale (22).

13. Sous-élément (1) selon l'une des revendications 11 ou 12, **caractérisé en ce qu'**au moins pour une partie des éléments de remplissage contenant du Nb (7, 8 ; 19, 20, 21 ; 24a-24h ; 28, 29), chaque élément de remplissage (7, 8 ; 19, 20, 21 ; 24a-24h ; 28, 29) présente, en section transversale
- une zone arrière (40) de la première phase contenant du Nb (P1), qui est radialement extérieure et adjacente à la barrière de diffusion (9), et
- une zone avant (41) de la deuxième phase contenant du Cu (P2), qui est radialement intérieure et adjacente à la zone de faisceau (4) et sépare la zone arrière (40) de la zone de faisceau (4).

14. Sous-élément (1) selon l'une des revendications 11 à 13, **caractérisé en ce qu'**au moins pour une partie des éléments de remplissage contenant du Nb (7, 8 ; 19, 20, 21 ; 24a-24h ; 28, 29), chaque élément de remplissage (7, 8 ; 19, 20, 21 ; 24a-24h ; 28, 29) présente, en section transversale
- comme structure en couches (30) avec plusieurs premières zones de couche (17) de la première phase contenant du Nb (P1) et plusieurs deuxièmes zones de couche (18) de la deuxième phase contenant du Cu (P2),
- et les premières zones de couche (17) et les deuxièmes zones de couche (18) alternent.

15. Sous-élément (1) selon l'une des revendications 11 à 14, **caractérisé en ce qu'**au moins pour une partie des éléments de remplissage contenant du Nb (7, 8 ; 19, 20, 21 ; 24a-24h ; 28, 29), chaque élément de remplissage (7, 8 ; 19, 20, 21 ; 24a-24h ; 28, 29) présente, en section transversale
- comme structure enroulée (31) avec une zone de couche enroulée (42) de la première phase contenant du Nb (P1) et une zone de couche enroulée (43) de la deuxième phase contenant du Cu (P2), ces zones de couche enroulées (42, 43) étant enroulées ensemble, et/ou
- comme structure multifilamentaire (25) avec une zone matricielle (26) de la deuxième phase contenant du Cu (P2) et plusieurs zones de filament (27) de la première phase contenant du Nb (P1), lesquelles sont disposées de manière répartie dans la zone matricielle (26).

16. Sous-élément (1) selon l'une des revendications 11 à 15, **caractérisé en ce qu'**au moins pour une partie des éléments de remplissage contenant du Nb (7, 8 ; 19, 20, 21 ; 24a-24h ; 28, 29), une ou plusieurs zones de la première phase contenant du Nb (P1) et une ou plusieurs zones de la deuxième phase contenant du Cu (P2) sont disposées de manière concentrique dans l'élément de remplissage contenant du Nb (7, 8 ; 19, 20, 21 ; 24a-24h ; 28, 29).

17. Sous-élément (1) selon l'une des revendications précédentes, **caractérisé en ce**
**qu'**au moins une partie des éléments de remplissage contenant du Nb (7, 8 ; 19, 20, 21 ; 24a-24h ; 28, 29) sont réalisés comme éléments de remplissage dopants (38), les éléments de remplissage dopants (38) contenant dans au moins une phase qu'ils renferment (P1, P2) au moins un élément du quatrième sous-groupe du tableau périodique,
et/ou
**que** dans la zone intermédiaire (6) sont également disposés des éléments d'addition dopants (16), les éléments d'addition dopants (16) contenant dans au moins une phase qu'ils renferment (P1, P2) au moins un élément du quatrième sous-groupe du tableau périodique,
notamment, au moins un élément du quatrième sous-groupe du tableau périodique comprenant du titane.

18. Sous-élément (1) selon l'une des revendications précédentes, **caractérisé en ce**
**qu'**au moins une partie des éléments de remplissage contenant du Nb (7, 8 ; 19, 20, 21 ; 24a-24h ; 28, 29) sont réalisés comme éléments de remplissage de renforcement (15), les éléments de remplissage de renforcement (15) contenant dans au moins une phase qu'ils renferment (P1, P2) au moins un élément du cinquième sous-groupe du tableau périodique,
et/ou
**que** dans la zone intermédiaire (6) sont également disposés des éléments d'addition de renforcement (39), les éléments d'addition de renforcement (39) contenant dans au moins une phase qu'ils renferment (P1, P2) au moins un élément du cinquième sous-groupe du tableau périodique, notamment, au moins un élément du cinquième sous-groupe du tableau périodique comprenant du tantale.

19. Sous-élément (1) selon l'une des revendications précédentes, **caractérisé en ce qu'**au moins pour une partie des éléments de remplissage contenant du Nb (7, 8 ; 19, 20, 21 ; 24a-24h ; 28, 29), chaque élément de remplissage (7, 8 ; 19, 20, 21 ; 24a-24h ; 28, 29)
- contient également du Sn,
- de préférence, chaque élément de remplissage (7, 8 ; 19, 20, 21 ; 24a-24h ; 28, 29) présente, en section transversale, au moins une zone d'une première phase contenant du Nb (P1) et au moins une zone d'une deuxième phase contenant du Cu (P2), et le Sn est contenu dans la phase contenant du Cu (P2),
- particulièrement de préférence, une zone centrale (22) de la première phase contenant du Nb (P1) est complètement entourée par une zone d'enrobage (23) de la deuxième phase contenant du Cu (P2), dans laquelle le Sn est également contenu.

20. Procédé de fabrication d'un fil supraconducteur Nb₃Sn (32), comprenant au moins les étapes suivantes :
Étape 1) fabrication (t1, t2) de plusieurs sous-éléments (1 ; 1') selon l'une des revendications précédentes ;
Étape 2) regroupement (t3, t4) de plusieurs sous-éléments fabriqués (1 ; 1') pour former un fil semi-fini (34 ; 34') ;
Étape 3) traitement thermique de réaction (t5, t6) du fil semi-fini (34 ; 34'), le Sn et le Nb du fil semi-fini (34 ; 34') réagissant pour former Nb₃Sn.
